# EUROPEAN PATENT APPLICATION

(11) **EP 2 469 581 A1**
(43) Date of publication of application: **27.06.2012**
(21) Application number: 10810049.6
(22) Date of filing: 17.08.2010
(51) Int. Cl.: H01L 21/205, C30B 29/38, H01L 21/336, H01L 21/8234, H01L 27/04, H01L 27/088, H01L 29/12, H01L 29/47, H01L 29/78, H01L 29/872

(54) **SEMICONDUCTOR ELEMENT AND PRODUCTION METHOD THEREOF**

(30) Priority: 20.08.2009 JP 2009191004; 07.05.2010 JP 2010107394
(71) Applicant: Powdec K.k., Kanagawa 241-0014 (JP)
(72) Inventor: SUMIDA, Yasunobu, Yokohama-shi Kanagawa 241-0014 (JP); HIRATA, Shoko, Yokohama-shi Kanagawa 241-0014 (JP); INADA, Takayuki, Yokohama-shi Kanagawa 241-0014 (JP); YAGI, Shuichi, Yokohama-shi Kanagawa 241-0014 (JP); KAWAI, Hiroji, Yokohama-shi Kanagawa 241-0014 (JP)
(74) Representative: Körber, Martin Hans
(86) International application number: PCT/JP2010/064133
(87) International publication number: WO 2011/021710

(57) **Abstract**

The method for manufacturing a semiconductor device comprises steps of: forming a growth mask with a plurality of openings directly or indirectly upon a substrate that comprises a material differing from GaN-based semiconductor; and growing a plurality of island-like GaN-based semiconductor layers upon the substrate using the growth mask in the (0001) plane orientation in a manner such that the 〈1-100〉 direction extends in a direction parallel to the striped openings of the growth mask.

## Description

### Technical Field

The present invention generally relates to a semiconductor device and a method for manufacturing thereof, especially, is preferable to apply to a semiconductor device using a gallium nitride (GaN) -based semiconductor.

### Background Art

In case that a high value semiconductor is obtained with high quality upon a low-priced substrate made of different materials, the industrial value is extremely high. Therefore, researches and developments have been proceeded to realize it for a long time. Especially, in a gallium arsenide (GaAs)-based semiconductor thin film growth upon a silicon (Si) substrate and a GaN-based semiconductor thin film growth upon a sapphire substrate, a relatively good semiconductor thin film can be obtained using a so-called a buffer layer technique, and have already been in practical use. However, in the conventional buffer layer technique, a lot of defects and threading dislocations exist in a semiconductor thin film grown. Therefore, the applications are stayed in a limited device such as a light-emitting diode (LED), etc.

The technique that brought a new break through for the present situation is the selective area growth (SAG) technique. For example, A. Usui et al. reduced the threading dislocations in the GaN layer dramatically wherein a substrate grown a GaN layer upon a sapphire substrate applying the heretofore known buffer layer technique is used as a base substrate, and upon the substrate, an insulator film made of silicon dioxide (SiO₂) is disposed in striped shape as a growth mask, and upon the portion without the insulator film (window), a GaN layer is grown selectively, and thereafter the GaN layer is laterally grown upon the insulator film(A. Usui, H. Sunakawa, A. Sasaki, and A. Yamaguchi: Jpn. J. Appl. Phys., 36, L899 (1997)). The technique has already been tried in the GaAs growth upon a Si substrate in 1982 (B-Y. Ysauer et al.: Appl. Phys. Lett., 41, 347 (1982)). The method aims to block spreading of threading dislocations from a ground layer by an insulator film and to reduce the threading dislocations by the lateral growth of a GaN layer upon the insulator film dramatically. Therefore, the method is often named ELO(Epitaxial Lateral Overgrowth) to emphasize the lateral growth.

Also, the GaN selective growth upon a Si substrate laminating thin AlGaN layer as an intermediate layer has already been reported by Y. Kawaguchi et al. in 1988. According to the report, ELO is basically possible, and the orientation relationship of crystal orientation of GaN and a ground Si substrate is given (Y. Kawaguchi et al., Jpn. J. Appl. Phys., 37 (1998) p. L966).

Now, the growth mask used to grow a GaN-based semiconductor by an ELO method is generally comprised with a striped mask portion with 3 to 10 µm in width and a striped window with the same width of the mask portion. In this case, the GaN layer laterally grown upon the growth mask from the window bumps into the GaN layer laterally grown from the next window and coalesces, covering the growth mask, thereby forming a joined GaN layer. In the GaN layer obtained by the above method, threading dislocations grow from the bottom surface in the window region and many dislocations by lattice mismatch exist in the joined portion. These portions can not be used as an active region of devices and have no other choice to form a striped active region in the limited region upon the stripes. The method has been tried to apply to manufacture of a narrow striped semiconductor laser, however is not put to practical use.

Generally, a base substrate and a semiconductor layer differ in materials, thermal expansion coefficient is different each other, and when the substrate temperature returns to room temperature after the growth of a semiconductor layer, compressive or tensile stress generates in the upper semiconductor layer, and the whole substrate is curved widely. For example, when a GaN layer is grown upon a sapphire substrate by an ELO method, the substrate is convex to the above. On the contrary, when a GaN layer is grown upon a Si substrate or a silicon carbide (SiC) substrate, etc. by an ELO method, the substrate is convex to the below. The curvature of the substrate becomes prominent when the thickness of the semiconductor layer becomes large, and in tremendous cases, cracks (trace of crack) occur in the semiconductor layer. Also, the curvature of the substrate makes the lithography process to form a device remarkably difficult, if not causes cracks in the semiconductor layer. Also, the portion of the GaN layer on the insulator film with less threading dislocations is limited to a narrow area with about several µm by the conventional technique, so only a several µm width stripe device such as a semiconductor laser, etc. can be manufactured.

The present invention aims to solve the above subjects existing in the conventional technique at a burst.

That is, the subject to be solved by the present invention is to provide a semiconductor device and a method for manufacturing thereof that enable to grow an island-like GaN-based semiconductor layer made of high quality semiconductor crystal upon a substrate made of different materials suppressing the curvature of the substrate, to suppress an occurrence of cracks, etc. even if a GaN-based semiconductor layer is quite thick, and to realize easily a semiconductor device with a large area.

### Disclosure of Invention

To solve the subjects, according to the present invention, there is provided a semiconductor device comprising:
a substrate that comprises a material differing from GaN-based semiconductor;
a growth mask with one or a plurality of striped openings disposed directly or indirectly upon the substrate; and
one or a plurality of island-like GaN-based semiconductor layers grown upon the substrate using the growth mask in the (0001) plane orientation,
the striped openings of the growth mask extending in a direction parallel to the 〈1-100〉 direction of the GaN-based semiconductor layer.

In the semiconductor device, the growth mask is disposed directly upon a substrate that comprises a material differing from a GaN-based semiconductor, that is, is disposed directly in contact, or is disposed indirectly through an intermediate layer, etc. made of a GaN-based semiconductor. An example of a substrate that comprises a material differing from a GaN-based semiconductor is a sapphire substrate or a Si substrate, etc., but is not limited to these substrates, and as long as enables to grow a GaN-based semiconductor layer in the (0001) plane orientation, any substrates can be used. In the semiconductor device, typically, the sides of the island-like GaN-based semiconductor layer is formed with the (1-10α) plane (α is an arbitrary integer), the (11-2β) plane (β is an arbitrary integer), or planes crystallographically equivalent to these, or, sides of the island-like GaN-based semiconductor layers include the (1-10α) plane (α is an arbitrary integer) . The growth mask is formed by an insulator film of a SiO₂ film or a SiN film, etc. As a preferable example, the growth mask comprises a plurality of striped openings which are arranged in the first direction parallel to the 〈11-20〉 direction of the GaN-based semiconductor layers and the second direction parallel to the 〈1-100〉 direction of the GaN-based semiconductor layers periodically at the first interval and the second interval respectively and extend in the second direction; and auxiliary striped openings disposed on the bisecting line of the region between a pair of the striped openings adjacent to each other in the first direction in a manner such that the auxiliary striped openings overlap with end portions opposing each other of a pair of the striped openings adjacent to each other in the second direction for the predetermined distance, respectively. As necessary, the auxiliary striped opening may not be disposed. The width of the auxiliary striped opening may be constant in the second direction, and may be changed in the second direction. The width of the striped opening is typically constant in the second direction, but may be changed in the second direction as necessary. As another preferable example, the growth mask comprises a plurality of striped openings which are arranged in the first direction parallel to the 〈11-20〉 direction of the GaN-based semiconductor layers periodically and extend in the second direction parallel to the 〈1-100〉 direction of the GaN-based semiconductor layers; and a plurality of striped openings which are arranged periodically in the first direction at the same interval as the striped openings and shifted by a half of the interval with respect to the striped openings and extends in the second direction in a manner such that the plurality of striped openings overlap with end portions of the striped openings for the predetermined distance in the second direction. The width of these striped openings is typically constant in the second direction, but as necessary, may be changed in the second direction. The GaN-based semiconductor layer comprises appropriately according to semiconductor devices, generally, comprises more than two layers including at least one layer among an n-type layer, an undoped layer and a p-type layer. The layers comprising the GaN-based semiconductor layer are, specifically, a GaN layer, an AlGaN layer, an AlGaInN layer, an InGaN layer, etc. In case the semiconductor device has a plurality of GaN-based semiconductor layers, the distance between island-like GaN-based semiconductor layers adjacent to each other is generally 30 µm or less, preferably 10 µm or less, but is not limited to these figures. In the semiconductor device, a number of electrodes according to the types of the semiconductor device are disposed at predetermined portions. The semiconductor device is, for example, a Schottky diode, a light-emitting diode, a semiconductor laser, a photodiode, a transistor, etc., but is not limited to these.

Also, according to the present invention, there is provided a method for manufacturing of a semiconductor device comprising steps of:
forming a growth mask with a plurality of striped openings directly or indirectly upon a substrate that comprises a material differing from GaN-based semiconductor; and
growing a plurality of island-like GaN-based semiconductor layers upon the substrate using the growth mask in the (0001) plane orientation in a manner such that the 〈1-100〉 direction of the GaN-based semiconductor layers extends in a direction parallel to the striped openings of the growth mask.
In the present invention of the method for manufacturing of a semiconductor device, the explanation relating to the present invention of the semiconductor device come into effect as far as not violating the character.

The method for manufacturing a semiconductor device may further comprise a step of bonding the first support substrate upon the upper surface side of the GaN-based semiconductor layers after growing the GaN-based semiconductor upon the substrate, and peeling the first support substrate and the GaN-based semiconductor layers off from the substrate, in addition, may further comprise a step of forming one or a plurality of electrodes upon the exposed surface of the GaN-based semiconductor layer after peeling the first support substrate and the GaN-based semiconductor layers off from the substrate. As necessary, the method for manufacturing a semiconductor device further comprise a step of forming one or a plurality of electrodes upon the upper surface of the GaN-based semiconductor layers after growing the GaN-based semiconductor layer upon the substrate and before bonding the first support substrate upon the upper surface side of the GaN-based semiconductor layers, or further comprise a step of removing at least a portion of, or preferably almost all, or the most preferably all of the growth mask, or further comprises both of the steps. Also, as necessary, a conductor thin film or a conductor line is formed upon the major surface of the first support substrate on the side bonded with the GaN-based semiconductor layer. The method for manufacturing a semiconductor device, as necessary, further may comprise a step of bonding the second support substrate upon the exposed surface side of the GaN-based semiconductor layer after peeling the first support substrate and the GaN-based semiconductor layers off from the substrate. The first support substrate and the second support substrate are made of elemental semiconductor, compound semiconductor, metal, alloy, nitride-based ceramics, oxide-based ceramics, diamond, carbon, plastic, etc., and may be a single layer structure, or a multilayer structure made of these materials. For the bonding of the first support substrate and the second support substrate, a metal for bonding such as solder, etc. or organic adhesive, etc. can be used, and is selected as necessary.

According to the present invention, the crystalinity of the island-like GaN-based semiconductor layer laterally growing upon the growth mask from a striped opening of the growth mask is very high, and the GaN-based semiconductor layer made of high quality semiconductor crystal can be obtained. Also, when a plurality of island-like GaN-based semiconductor layers are grown, these layers are separated each other, that is, is formed in isolation, so tensile stress or compressive stress generated in each GaN-based semiconductor layer is limited within the GaN-based semiconductor layer, and the effect by these tensile stress or compressive stress does not fall upon the other GaN-based semiconductor layers. Also, as the growth mask and the GaN-based semiconductor layer are not bonded chemically, the stress in the GaN-based semiconductor layer can be relaxed by the slide causing at the interface between the growth mask and the GaN-based semiconductor layer. Also, by existence of gaps between the island-like GaN-based semiconductor layers each other, the whole substrate growing a plurality of island-like GaN-based semiconductor layers has the flexibility, therefore, it is easily deformed when external force is applied, and can be bended. Therefore, even if there occurs slightly warpage, curvature, deformation in the substrate, they can be easily corrected by small external force, handling of substrates by vacuum chucking is possible, the manufacturing process of semiconductor devices can be easily carried out. As explained, island-like GaN-based semiconductor layers made of high quality semiconductor crystal can be grown suppressing the curvature of the substrate, and further even the GaN-based semiconductor layer is very thick, the occurrence of crack, etc. can be suppressed, thereby a large area semiconductor device can be easily realized.

### Brief Description of Drawings

Fig. 1A and Fig. 1B are cross-sectional views for explaining the method for manufacturing a GaN-based semiconductor device according to the first embodiment of the present invention.
Fig. 2 is a plan view showing an example of a growth mask used in the method for manufacturing a GaN-based semiconductor device according to the first embodiment of the present invention.
Fig. 3 is a plan view showing another example of a growth mask used in the method for manufacturing a GaN-based semiconductor device according to the first embodiment of the present invention.
Fig. 4 is a schematic view for explaining the second method to prevent the coalescence of GaN-based semiconductor layers each other in the method for manufacturing the GaN-based semiconductor device according to the first embodiment of the present invention.
Fig. 5 is a schematic view for explaining the third method to prevent the coalescence of GaN-based semiconductor layers each other in the method for manufacturing a GaN-based semiconductor device according to the first embodiment of the present invention.
Fig. 6 is a schematic view for explaining the third method to prevent the coalescence of GaN-based semiconductor layers each other in the method for manufacturing a GaN-based semiconductor device according to the first embodiment of the present invention.
Fig. 7 is a schematic view for explaining the fourth method to prevent the coalescence of GaN-based semiconductor layers each other in the method for manufacturing a GaN-based semiconductor device according to the first embodiment of the present invention.
Fig. 8 is a drawing substitute photograph showing a scanning electron microscope image of the surface of the GaN-based semiconductor layer grown using the growth mask shown in Fig. 2 in the method for manufacturing a GaN-based semiconductor device according to the first embodiment of the present invention.
Fig. 9 is a drawing substitute photograph showing a scanning electron microscope image of the surface of the GaN-based semiconductor layer grown using a growth mask which is not formed an auxiliary striped window.
Fig. 10 is a plan view showing the growth mask formed for measuring the change of the amount of lateral growth according to the angle from the 〈11-20〉 direction in the longitudinal direction of a striped window in the GaN (0001) plane growth.
Fig. 11 is a schematic view showing the measuring results of the change of the amount of lateral growth according to the angle from the 〈11-20〉 direction in the longitudinal direction of a striped window in the GaN (0001) plane growth.
Fig. 12A and Fig. 12B are cross-sectional views for explaining the method for manufacturing a GaN-based Schottky diode according to the second embodiment of the present invention.
Fig.13A and Fig. 13B are cross-sectional views for explaining the method for manufacturing a GaN-based Schottky diode according to the second embodiment of the present invention.

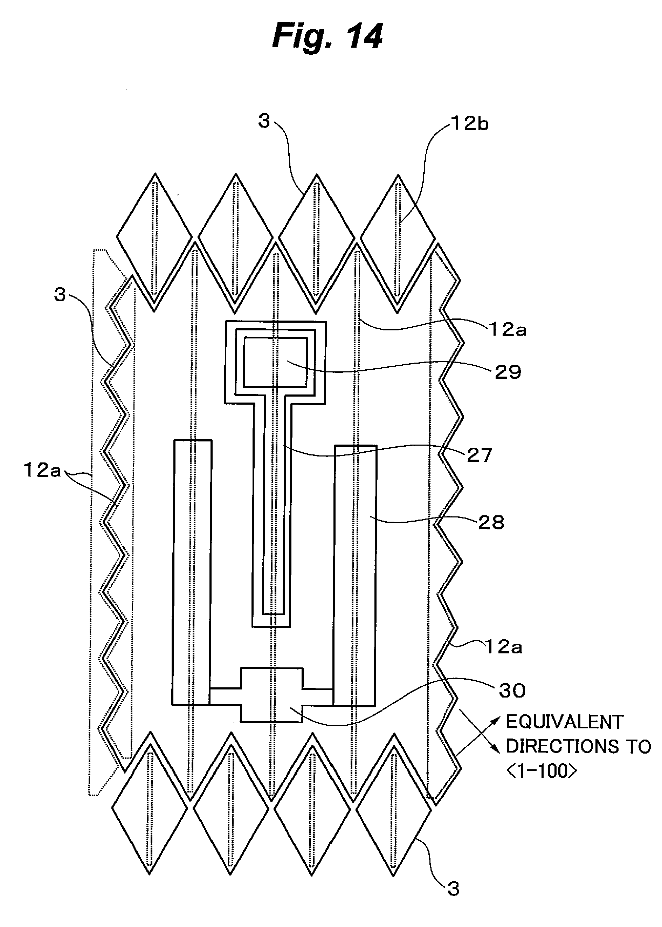

Fig. 14 is a plan view for explaining the method for manufacturing a GaN-based Schottky diode according to the second embodiment of the present invention.
Fig. 15A and Fig. 15B are cross-sectional views for explaining the method for manufacturing a GaN-based Schottky diode according to the third embodiment of the present invention.
Fig. 16A and Fig. 16B are cross-sectional views for explaining the method for manufacturing a GaN-based Schottky diode according to the fourth embodiment of the present invention.
Fig. 17A and Fig. 17B are cross-sectional views for explaining the method for manufacturing a GaN-based MISFET according to the fifth embodiment of the present invention.
Fig. 18A and Fig. 18B are cross-sectional views for explaining the method for manufacturing a GaN-based semiconductor device according to the seventh embodiment of the present invention.
Fig. 19 is a cross-sectional view for explaining the method for manufacturing a GaN-based semiconductor device according to the seventh embodiment of the present invention.
Fig. 20 is a cross-sectional view for explaining the method for manufacturing a GaN-based semiconductor device according to the seventh embodiment of the present invention.
Fig. 21 is a cross-sectional view for explaining the method for manufacturing a GaN-based semiconductor device according to the seventh embodiment of the present invention.
Fig. 22 is a cross-sectional view for explaining the method for manufacturing a GaN-based semiconductor device according to the seventh embodiment of the present invention.
Fig. 23 is a perspective view for explaining the method for manufacturing a GaN-based semiconductor device according to the seventh embodiment of the present invention.
Fig. 24 is a drawing substitute photograph showing a scanning electron microscope image of the surface of the GaN-based semiconductor layer peeled off from the base substrate in the method for manufacturing a GaN-based semiconductor device according to the seventh embodiment of the present invention.
Fig. 25A and Fig. 25B are drawing substitute photographs showing a scanning electron microscope image enlarged the end portion and the central portion of the GaN-based semiconductor layer shown in Fig. 24.
Fig. 26 is a cross-sectional view for explaining the method for manufacturing a GaN-based Schottky diode according to the eighth embodiment of the present invention.
Fig. 27 is a plan view for explaining the method for manufacturing a large area power GaN-based Schottky diode according to the ninth embodiment of the present invention.
Fig. 28 is a cross-sectional view for explaining the method for manufacturing a GaN-based light-emitting diode according to the eleventh embodiment of the present invention.
Fig. 29 is a cross-sectional view for explaining the method for manufacturing a two-terminal and a three-terminal GaN-based compound semiconductor device according to the twelfth embodiment of the present invention.
Fig. 30 is a schematic view showing an equivalent circuit of a two-terminal and a three-terminal GaN-based compound semiconductor device shown in Fig. 29.
Fig. 31A and Fig. 31B are plan views showing an example of a growth mask used in the method for manufacturing a GaN-based semiconductor device according to the thirteenth embodiment of the present invention.
Fig. 32A and Fig. 32B are plan views showing an example of a growth mask used in the method for manufacturing a GaN-based semiconductor device according to the fourteenth embodiment of the present invention.

### Best Mode for Carrying Out the Invention

The best mode for the embodiments of the present invention (hereafter refer to embodiment) is explained in detail below. The

### first embodiment

A GaN-based semiconductor device and a method for manufacturing thereof according to the first embodiment are explained.

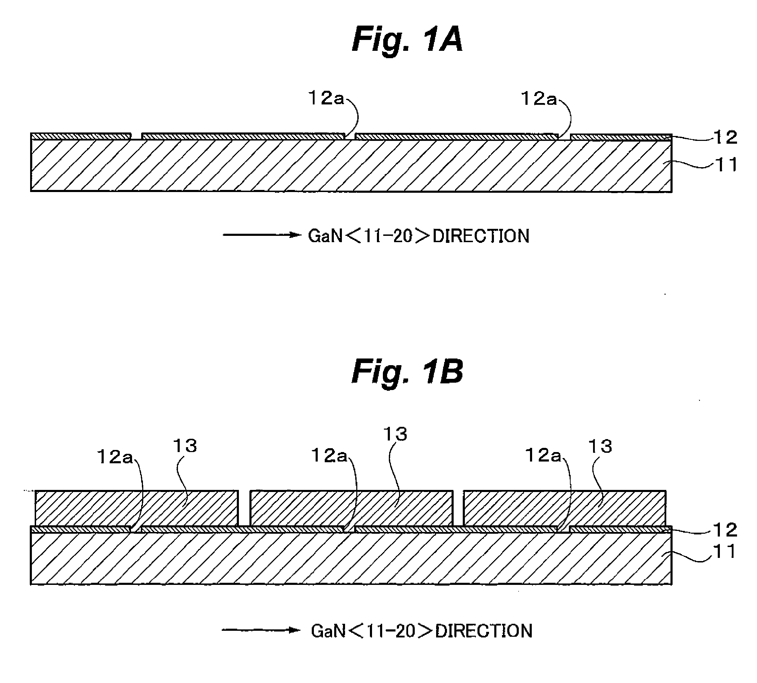

In the first embodiment, as shown in Fig. 1A, first, upon a base substrate 11, a growth mask which has a plurality of striped openings (hereafter refer to a striped window) 12a and, as necessary, in addition to them a plurality of auxiliary striped openings (hereafter refer to an auxiliary striped window) to be described later is formed. As the base substrate 11, a substrate made of different materials from the GaN-based semiconductor, for example, a C-plane sapphire substrate or a (111) plane-oriented Si substrate, etc., for example upon which a GaN-based semiconductor layer such as a GaN layer, etc. is grown in the (0001) plane orientation may be used, or a C-plane sapphire substrate itself may be used. The thickness of the GaN-based semiconductor layer such as a GaN layer, etc. to be grown upon the C-plane sapphire substrate or the (111) plane-oriented Si substrate, etc. is 1 to 2 µm, for example, but is not limited to these. The growth mask 12 can be formed by forming an insulator film, for example, a SiO₂ film upon the base substrate 11, for example, by a plasma chemical vapor deposition (CVD) method, etc., for example, and patterning the SiO₂ film by photolithography using a predetermined photo mask and etching. The thickness of the SiO₂ film is to be 0.3 µm, for example, but is not limited to the figure. The shape and configuration of the striped window 12a and the auxiliary striped window of the growth mask 12 will be described later.

Next, as shown in Fig. 1B, using the growth mask 12, a GaN-based semiconductor layer 13 is grown in an island-like shape in the (0001) plane orientation by a vapor-phase deposition method, for example, a metalorganic chemical vapor deposition (MOCVD) method. In this case, first upon the surface of the base substrate 11 exposed upon the striped window 12a, a GaN-based semiconductor is selectively grown, and is continuously laterally grown upon the grown mask 12, thereby the GaN-based semiconductor layer 13 is grown upon the growth mask 12. At the growth, before an island-like GaN-based semiconductor layer 13 strikes with an adj acent island-like GaN-based semiconductor layer 13, the growth is stopped. Whether the island-like GaN-based semiconductor layer 13 is made grow from how many striped windows 12a can be decided as necessary. In Fig. 1B, a case is illustrated that one island-like GaN-based semiconductor layer 13 is grown from the striped window 12a, but one island-like GaN-based semiconductor layer 13 may be grown from two or more striped windows 12a. The GaN-based semiconductor layer 13 is composed of two or more layers including at least one layer among an n-type layer, an undoped layer, and a p-type layer, according to a GaN-based semiconductor device to be manufactured.

Next, each GaN-based semiconductor layer 13 of island-like shape grown upon the growth mask 12 by the above is processed as necessary, and further, is formed with necessary electrodes (not illustrated) .

After this, the base substrate 11 formed a device structure as described above, for example, is chipped in a manner such that one island-like GaN-based semiconductor layer 13 is included in one chip, thereby an intended GaN-based semiconductor device is manufactured.

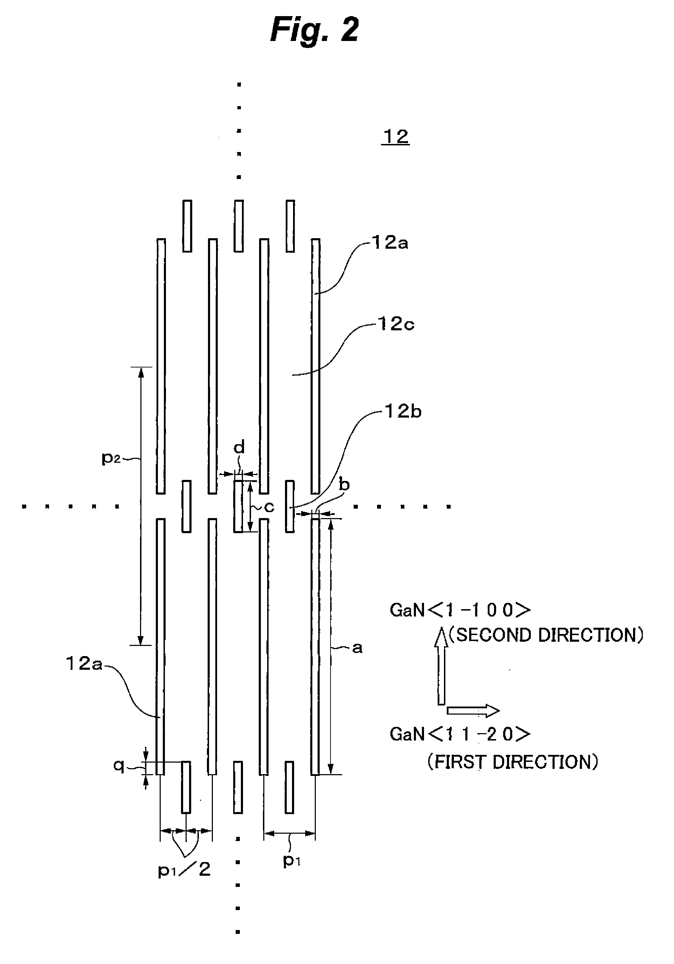

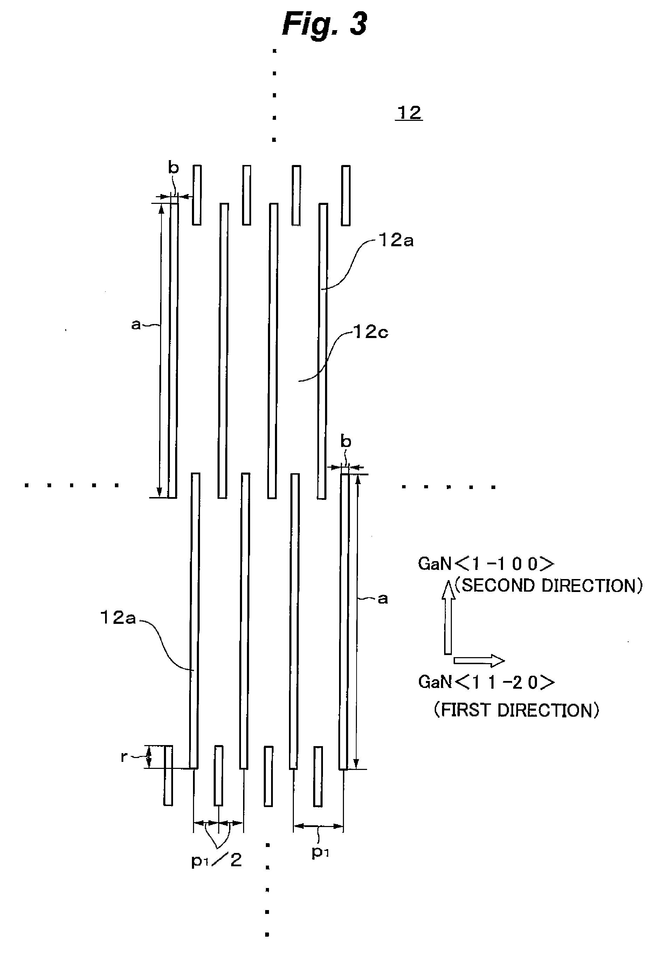

The details of the growth mask 12 are explained. The two examples of the growth mask 12 are shown in Fig. 2 and Fig. 3.

The growth mask shown in Fig. 2 comprises a plurality of striped window 12a which are arranged in the first direction parallel to the 〈 11-20 〉 direction of the (0001) plane-oriented GaN-based semiconductor layers 13 and the second direction parallel to the 〈 1-100 〉 direction of the GaN-based semiconductor layers 13 periodically at the intervals p₁ and p₂ respectively and extend in the second direction. The growth mask 12 has further comprises auxiliary striped windows 12b disposed on the bisecting line of the region between a pair of the striped window 12a adjacent to each other in the first direction in a manner such that the auxiliary striped windows 12b overlap with end portions opposing each other of a pair of the striped openings 12a adjacent to each other in the second direction for the length q, respectively. The auxiliary striped window 12b is, as described later, the one to prevent embossment of both end portions in the 〈1-100〉direction of the GaN-based semiconductor layer 13. The length of the striped window 12a is a, the width is b, the length of the auxiliary striped window 12b is c, and the width is d. A portion other than the striped window 12a and the auxiliary striped window 12b in the growth mask 12 is a mask portion 12c. The length a of the striped window 12a is, for example, 200 to 2000 µm, the width b is, for example, 2 to 20 µm, the interval p₁ of the striped window 12a is, for example, 6 to 120 µm, the interval p₂ is, for example, 505 to 1050 µm, the length c of the auxiliary striped window 12b is given about ((p₂ - a) + (p₁ - b - d) ÷ tan 30°), but in case a = 800 µm, b = 5 µm, d = 5 µm, p₁ = 55 µm, p₂ = 810 µm, the length c is 80 to 90 µm. The width d is, for example, the same as the width b. The width of the mask portion 12c is, for example, 50 µm as p₁ - b, the overlapping length q of the auxiliary striped window 12b with the striped window 12a is 35 to 40µm in case of the above setting as (p₁ - b - d) ÷ tan 30°÷ 2.

The growth mask 12 shown in Fig. 3 comprises a plurality of striped window 12a which are arranged in the first direction parallel to the 〈 11-20 〉 direction of the (0001) plane-oriented GaN-based semiconductor layers 13 periodically with the interval p₁ and extend in the second direction parallel to the 〈1-100〉 direction of the GaN-based semiconductor layers 13. To prevent embossment of both end portions in the 〈1-100〉direction of the GaN-based semiconductor layer 13 as described later, the growth mask 12 comprises further a plurality of striped windows 12a which are arranged periodically in the first direction at the same interval p₁ as the striped window 12a and shifted by a half of the interval p₁ with respect to the striped window 12a and extends in the second direction in a manner such that the plurality of striped windows 12a overlap with end portions of the striped windows 12a for the length r in the second direction. The length a of the striped window 12a is, for example, 200 to 2000 µm, the width b is, for example, 2 to 20 µm, the interval p₁ of the striped window 12a is, for example, 6 to 120 µm, the width of the mask portion 12c is, for example, p₁ - b, so, in case of p₁ = 55 µm and b = 5 µm, is 50 µm. The overlapping length r of the end portions each other of the striped window 12a is (p₁ - b - d) ÷ tan 30°÷ 2, therefore, in case of p₁ = 55 µm, and b = 5 µm, d = 5 µm, is 35 to 40 µm.

Growing the GaN-based semiconductor layer 13 using the growth mask 12 shown in Fig. 2 or Fig. 3, following advantages can be obtained.

Although the details are described later, in the (0001) plane growth of a GaN-based semiconductor, the lateral growth rate parallel to the plane is the biggest in the 〈11-20〉 direction, and is the smallest in the 〈1-100〉 direction. In the growth mask 12 shown in Fig. 2 or Fig. 3, as the longitudinal direction of the striped window 12a is the 〈1-100〉 direction, the growth rate of the GaN-based semiconductor is small at the both ends of the striped window 12a, the island-like GaN-based semiconductor layers 13 opposing each other in the 〈1-100〉 direction do not coalesce, and the island-like GaN-based semiconductor layers 13 can be separated each other. At this time, the size of the island-like GaN-based semiconductor layer 13 in the 〈1-100〉 direction becomes nearly equal with the length a of the striped window 12a.

On the other hand, as the lateral growth rate in the 〈11-20〉 direction from the striped window 12a is very fast, it is necessary for the island-like GaN-based semiconductor layers 13 not to coalesce each other in the 〈11-20〉 direction. For this, in the first method, the distance between the striped window 12a and the striped window 12a in the 〈11-20〉 direction, that is, the width of (p₁ - b) of the mask portion 12c in the 〈11-20〉 direction makes larger than the designed width in the 〈11-20〉 direction of the GaN-based semiconductor layer 13. By the method, the side in the direction that intersects at right angle in the 〈11-20〉 direction of the GaN-based semiconductor layer 13 becomes a 〈11-20〉 plane or an inclined (11-2β) plane (β is an arbitrary integer).

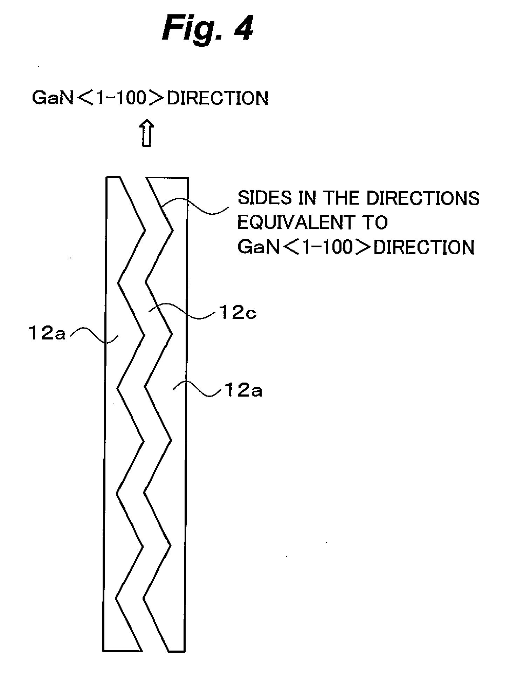

By the second method, as shown in Fig. 4, upon the growth mask 12 at the portion directly inside the end portions of the designed GaN-based semiconductor layer 13 in the 〈11-20〉 direction, a zigzag striped window 12a with a side in the equivalent directions with the 〈1-100〉 direction in which the growth rate is the smallest. By this, the lateral growth rate in the 〈11-20〉direction of the GaN-based semiconductor layer 13 can be reduced drastically, and the coalescence of the island-like GaN-based semiconductor layers 13 each other in the 〈11-20〉 direction can be prevented. By the method, the sides of the both end portions in the 〈11-20〉 direction of the GaN-based semiconductor layer 13 become a zigzag (1-100) plane or an inclined (1-10α) plane (α is an arbitrary integer).

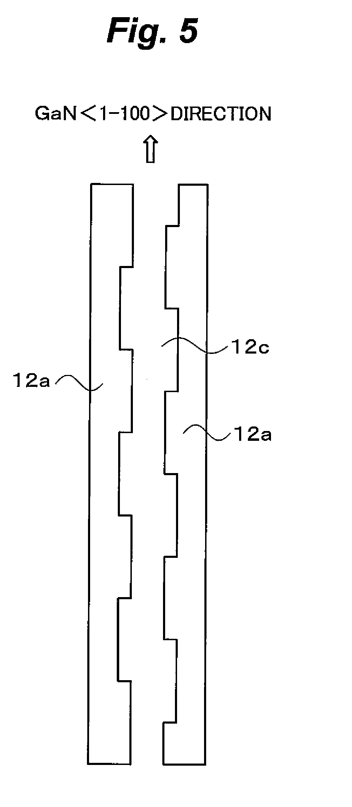

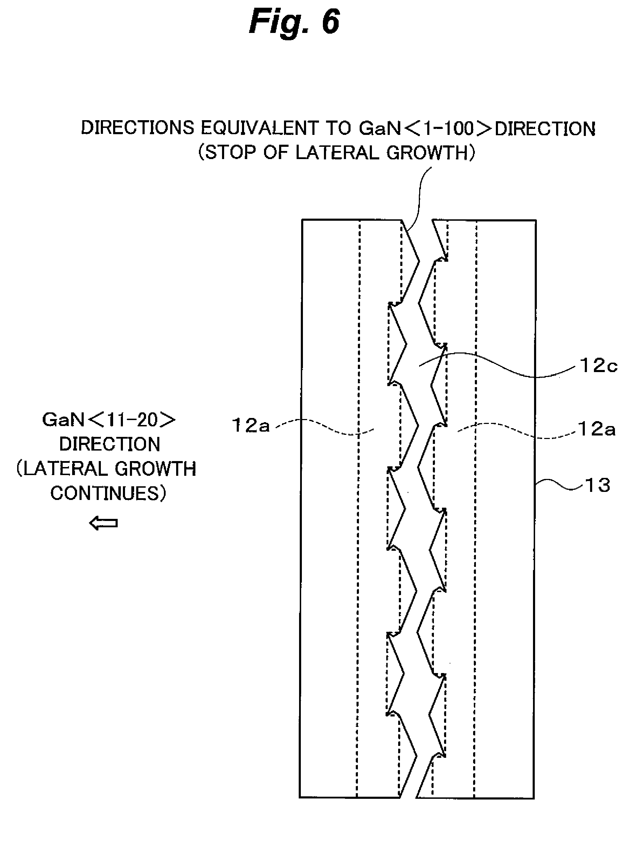

According to the third method, as shown in Fig. 5, upon the growth mask 12 at the portion directly inside the both end portions of the designed GaN-based semiconductor layer 13 in the 〈11-20〉 direction, the striped window 12a is formed so as to have an uneven side with a linear portion parallel to the 〈1-100〉 direction in which the growth rate is the smallest, and a linear portion parallel to the 〈11-20〉 direction alternately at both sides of the mask portion 12c. In this case, growing the GaN-based semiconductor layer 13, as shown Fig. 6, at the linear portion parallel to the 〈1-100〉 direction of the side of both sides of the mask portion 12c of the striped window 12a, the GaN-based semiconductor layer 13 grows in the 〈11-20〉 direction, but at the corner crossing the linear portion parallel to the 〈1-100〉 direction and the linear portion parallel to the 〈11-20〉 direction, the growth in the 〈11-20〉 direction can not be made, and at the corner, as the result the (1-10α) plane (α is an arbitrary integer) with slow growth appear dominantly, the sides of the both ends in the 〈11-20〉 direction of the GaN-based semiconductor layer 13 become a zigzag (1-100) plane. In Fig. 5, the uneveness of a pair of sides opposing each other of the striped window 12a at both sides of the mask portion 12c is shifted by a half of the interval in the 〈1-100〉 direction each other, but the shifted amount is not limited especially, for example, may be shifted by an interval in the 〈1-100〉 direction.

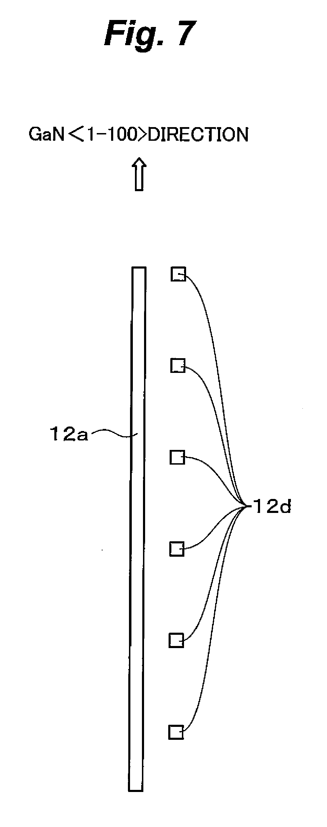

According to the third method, as shown in Fig. 7, in the growth mask 12, along the striped window 12a extending in the 〈1-100〉 direction, a dot-like opening (hereafter refer to a dot window) 12d of a square or a rectangle made of a side parallel to the 〈1-100〉 direction and a side parallel to the 〈11-20〉 direction is formed in the 〈1-100〉 direction in a plural number, preferably with equal distance, and is separated from each other. In this case, growing the GaN-based semiconductor layer 13, the growth of the GaN-based semiconductor layer 13 is blocked at the position of the dot window 12d, and the result is that the (1-10α) plane (α is an arbitrary integer) of which growth is slow appears dominantly.

By the way, in the island-like GaN-based semiconductor layer 13 enclosed with planes including planes with small growth rate, when the distance between the GaN-based semiconductor layer 13 and the GaN-based semiconductor layer 13 opposing planes with small growth rate each other is large, the following disadvantages occur. That is, in the mask portion 12c of the growth mask 12 of the region between the GaN-based semiconductor layer 13 and the GaN-based semiconductor layer 13, as the raw gas is not consumed there, the gas concentration goes up, and the concentration gradient is generated in the direction joining the GaN-based semiconductor layer 13 and the GaN-based semiconductor layer 13, and by the diffusion according to the concentration gradient, a lot of raw gas is supplied at the edge portion of the GaN-based semiconductor layer 13. As the result, the thickness of the edge portion of the GaN-based semiconductor layer 13 becomes larger in comparison with other portions, and becomes a raised shape. More specifically, at the mask portion 12c of the growth mask 12 of the region between the GaN-based semiconductor layer 13 and the GaN-based semiconductor layer 13 in the 〈1-100〉 direction of which growth rate is the smallest, the raw gas is not consumed there, therefore the gas concentration goes up, and the concentration gradient in the 〈1-100〉 direction is generated, and by the diffusion according to the concentration gradient, a lot of raw gas is supplied at the edge portion in the 〈1-100〉 direction of the GaN-based semiconductor layer 13. As the result, the thickness of the edge portion in the 〈1-100〉 direction of the GaN-based semiconductor layer 13 becomes larger in comparison with other portions, and becomes a raised shape. The specific raised shape of the edge portion of the GaN-based semiconductor layer 13 causes not only structural inconveniences of a GaN-based semiconductor device but also creates problems in the following manufacturing processes of photolithography, etc.

To prevent ununiformity of the thickness of the island-like GaN-based semiconductor layer 13 caused by a specific raised shape of the edge portion, the GaN-based semiconductor layer 13 and the GaN-based semiconductor layer 13 come close as much as possible, and it is necessary not to create in-plane ununiformity of raw gas from the beginning of the growth. For this, in the growth mask 12 shown in Fig. 2, upon the bisecting line of the region between a pair of striped windows 12a adjacent to each other in the 〈11-20〉 direction, the auxiliary striped window 12b is formed in a manner such that the auxiliary striped window 12b overlap with the opposing end portions of the striped windows 12a adjacent to each other in the 〈1-100〉 direction for the length q, respectively, in other words, the auxiliary striped window 12b is formed in the center of the region coming cross the four end portions of four striped windows 12a, thereby in-plane uniformity of gas concentration can be obtained by the consumption of raw gas caused by growing the island-like GaN-based semiconductor layer 13 from the auxiliary striped windows 12b also. Also, in the growth mask 12 shown in Fig. 3, the striped window 12a is arranged shifting by a half of the interval p₁ in the 〈11-20〉 direction each other, and the end portions of the striped window 12a in the 〈1-100〉 direction is overlapped for the length r each other, in other words, the striped windows 12a each other arranged by shifting by a half of the interval p₁ in the 〈11-20〉 direction is penetrated by the length r in the 〈1-100〉 direction, thereby in-plane uniformity of gas concentration can be obtained.

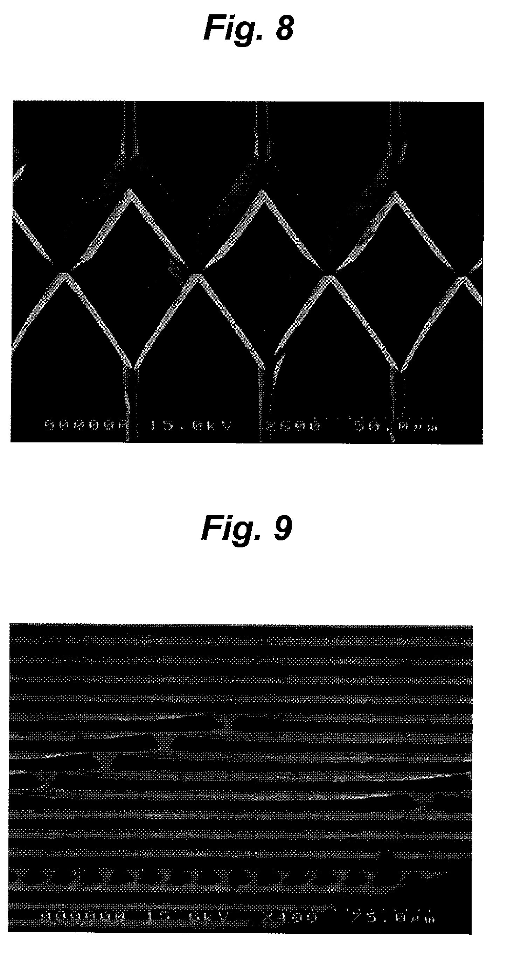

A scanning electron microscope image (SEM image) of the surface of the GaN-based semiconductor layer 13, here a GaN layer grown into an island-like shape by a MOCVD method using the growth mask 12 shown in Fig. 2 is shown in Fig. 8. Here, as the base substrate 11, a substrate grown a 2-µm-thick GaN layer upon a C-plane sapphire substrate is used. The growth mask 12 is formed with a 0.3-µm-thick SiO₂ film, the length a of the striped window 12a is 800 µm, the width b is 5 µm, the interval p₁ of the striped window 12a is 55 µm, the interval p₂ is 810 µm, the width of the mask portion 12c is 50 µm, the length c of the auxiliary striped window 12b is 80 µm, the width d is 5 µm, the distance between the striped window 12a and the striped window 12a in the 〈1-100〉 direction is 10 µm, the overlapping length q between the end portion of the striped window 12a and the auxiliary striped window 12b is 35 µm. The length c = 80 µm of the auxiliary striped window 12b is obtained by dividing the width 50 µm of the mask portion 12c with tan 30°. The thickness of the GaN layer grown into an island shape is 5 µm. The growth of the GaN layer is made at the temperature of 1100°C, and the pressure of 30 kPa. At the growth of the GaN layer, trimethylgallium (TMG) and ammonia (NH₃) are used as raw gas, and hydrogen (H₂) and nitrogen (N₂) are used as carrier gas. As shown in Fig. 8, the GaN-based semiconductor layer 13 is grown into a long and thin hexagonal island shape centering each a striped window 12a, and the GaN-based semiconductor layer 13 is grown into a rhombic island shape centering each auxiliary striped window 12b, and the swell at the edge portion in the 〈1-100〉 direction of the thin and long hexagonal island-like GaN-based semiconductor layer 13 can be prevented. The arrow in Fig. 8 shows the 〈1-100〉 direction. On the other hand, the SEM image of the surface of the GaN-based semiconductor layer 13 grown into an island shape using a growth mask without the auxiliary striped window 12b is shown in Fig. 9. As shown in Fig. 9, the edge portion of the both ends in the 〈1-100〉 direction of the long and thin hexagonal island-like GaN-based semiconductor layer 13 has a swelling portion.

In case forming one side surface of the island-lake GaN-based semiconductor layer 13 by the plane in the direction intersecting at right angle with the 〈1-100〉 direction, the side growth is stopped as described, so the distance between the GaN-based semiconductor layers 13 adjacent to each other is large, the thickness of the edge portions of the GaN-based semiconductor layer 13 in the 〈1-100〉 direction becomes large, which causes problems in the following photolithography process. Therefore, the distance between the GaN-based semiconductor layers 13 adjacent to each other is needed to become small as much as possible. According to the experiment, the distance is 20 µm or less, preferably 10 µm or less.

Next, explained are details about that in the (0001) plane growth of a GaN-based semiconductor, the lateral direction growth rate in the direction parallel to the plane is the largest in the 〈11-20〉 direction, and is the smallest in the 〈1-100〉 direction.

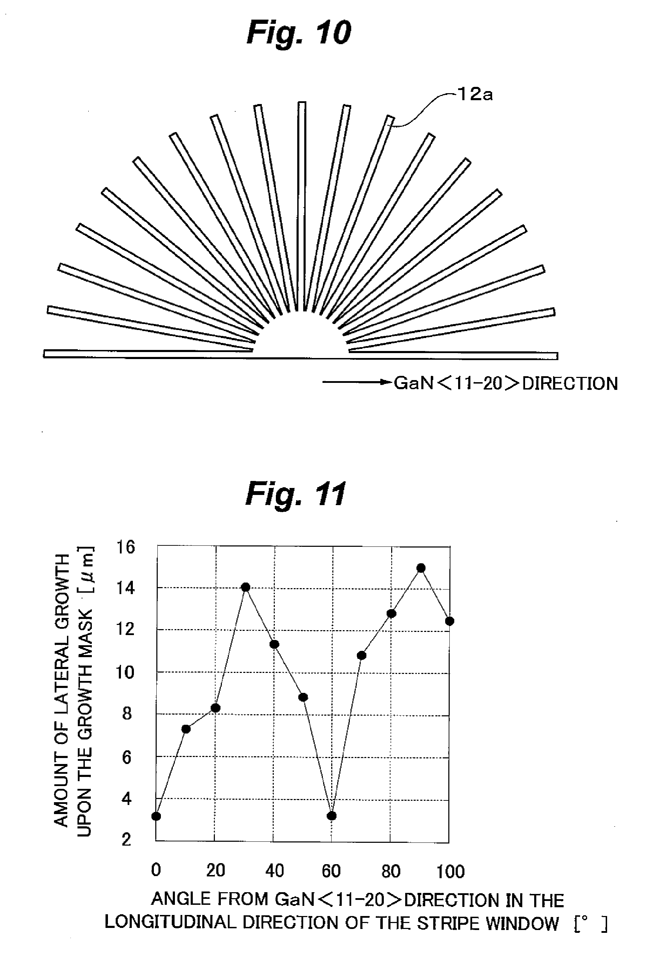

As a base substrate, a substrate grown a 2-µm-thick GaN layer upon a C-plane sapphire substrate by an MOCVD method is used. Next, upon the base substrate, a 0.3-µm-thick SiO₂ film is formed by a plasma CVD method. Next, as shown in Fig. 10, the striped window 12a, 800 µm in length and 20 µm in width each, is formed in fan shapes every 10° angle by photolithography and etching. The lateral direction in Fig. 10 is angle 0°. The direction of the angle 0° is in the direction which the longitudinal direction of the striped window 12a is in the 〈11-20〉 direction, and the direction that GaN grows in just the 〈1-100〉 direction from the striped window 12a. The substrate formed the striped window 12a in a fan shape upon a base substrate is brought in an MOCVD device again, and by an MOCVD method, GaN layer is selectively grown from the striped window 12a, and the lateral growth amount (length) of GaN layer upon the growth mask 12 is measured. The growth of the GaN layer is made at the temperature of 1100°C and the pressure of 30 kPa. At the growth of the GaN layer, TMG and NH₃ are used as raw gas, and H₂ and N₂ are used as carrier gas. The results are shown in Fig.11. The abscissa axis in Fig. 11 is the angle from the GaN 〈11-20〉 direction of the longitudinal direction of the striped window 12a, and the vertical axis shows the lateral growth amount upon the growth mask 12a. As shown in Fig. 11, when the angles are 30° and 90° from the 〈11-20〉 direction of the longitudinal direction of the striped window 12a, in other words, when the longitudinal direction of the striped window 12a is in the 〈1-100〉 direction, the lateral growth amount of the GaN layer upon the growth mask 12 in the 〈11-20〉 direction is about 14 µm. For this, when the angle from the 〈11-20〉 direction of the longitudinal direction of the striped window 12a is 0° and 60°, in other words, when the longitudinal direction of the striped window 12a is in the 〈11-20〉 direction, the lateral growth amount upon the growth mask 12 in the 〈1-100〉 direction is about 3 µm, which is quite small. Accordingly, it can be said that the GaN layer does not grow in the 〈1-100〉 direction practically. As well, the side of the GaN layer in the 〈1-100〉 direction tends to incline, and in the (1-10α) plane, α is between -2 to 2. The α = 0 is a vertical plane. Accordingly, in case growing an island-like GaN-based semiconductor layer, it is possible to lay out with the (1-100) plane.

According to the first embodiment, the crystalinity of the GaN-based semiconductor layer 13 grown upon the growth mask 12 from a plurality of striped windows 12a of the growth mask 12 is quite good. Also, as a plurality of the island-like GaN-based semiconductor layers 13 are formed by separating each other, the tensile stress or compressive stress generated in each GaN-based semiconductor layer 13 at the growth and the recovery to room temperature is limited only in the GaN-based semiconductor layer 13, and these tensile stress or compressive stress do not affect other GaN-based semiconductor layers 13. Also, the growth mask 12 and the GaN-based semiconductor layer 13 are not chemically bonded, so the stress in a GaN-based semiconductor layer 13 is relaxed by slide occurred at the interface between the growth mask 12 and the GaN-based semiconductor layer 13. Also, as gaps exist between island-like GaN-based semiconductor layers 13 each other, the base substrate 11 grown the GaN-based semiconductor layer 13 as a whole has flexibility, and when external force is applied, the base substrate 11 is easily deformed and can be bended. Therefore, even if small warpage, curvature and deformation, etc. exist in the base substrate 11, it is possible to correct them easily by small external force, and the handling of the base substrate 11 by vacuum chucking becomes possible, and the manufacturing process of a GaN-based semiconductor device can be executed easily.

From the above, the island-like GaN-based semiconductor layer 13 made of high quality semiconductor crystal can be grown suppressing curvature of the base substrate 11, further even the GaN-based semiconductor layer 13 is very thick, the generation of cracks, etc. can be suppressed, thereby a large area GaN-based semiconductor device can be realized easily.

### The second embodiment

A GaN-based Schottky diode and the method for manufacturing thereof according to the second embodiment are explained.

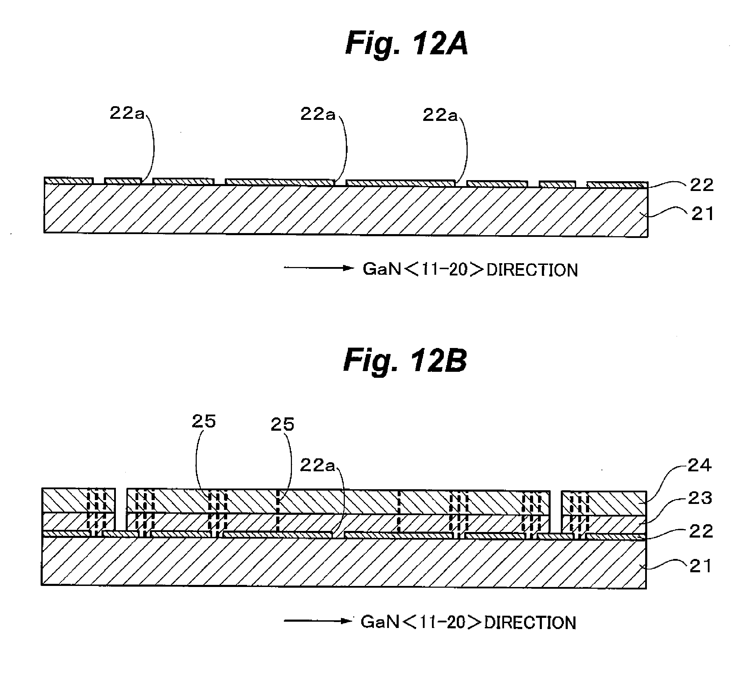

First, as the same as the first embodiment, as shown in Fig. 12A, a growth mask 22 is formed upon a base substrate 21. As the base substrate 21, a substrate grown a 2-µm-thick GaN layer upon a C-plane sapphire substrate is used. The growth mask 22 comprises a striped window 22a and an auxiliary striped window (not illustrated) as the same as the growth mask 12 shown in Fig. 2, and the striped window 22a of the growth mask 22 directly inside portion of both end portions of a designed GaN-based semiconductor layer in the 〈11-20〉 direction has zigzag shape with a side in equivalent directions as the 〈1-100〉 direction as shown in Fig. 4. For example, the growth mask 22 is formed with a 0.3-µm-thick SiO₂ film, the length a of the striped window 22a is 800 µm, the width b is 5 µm, the interval p₁ of the striped window 22a is 55 µm, the interval p₂ is 810 µm, the width of a mask portion is 50 µm, the length c of the auxiliary striped window is 80 µm, the width d is 5 µm, the distance between the striped window 22a and the striped window 22a in the 〈1-100〉 direction is 5 µm, the overlapping length q of the end portion of the striped window 22a and the auxiliary striped window 22b is 35 µm.

Next, as shown in Fig. 12B, using the growth mask 22, an n⁺-type GaN layer 23 doped with Si as an n-type impurity is grown into an island-like shape in the (0001) plane orientation by an MOCVD method. The thickness of the n⁺-type GaN layer 23 is, for example, 8 µm, the impurity concentration is, for example, 5 x 10¹⁸cm⁻³. The distance between the n⁺-type GaN layer 23 and the n⁺-type GaN layer 23 is, for example, about 10 µm. The growth of the n⁺-type GaN layer 23 is, for example, made at the temperature of 1100°C and the pressure of 30 kPa. At the growth of the n⁺-type GaN layer 23, for example, TMG and NH₃ are used as raw gas, H₂ and N₂ are used as carrier gas, silane (SiH₄) diluted with nitrogen is used as n-type dopant. In this case, one island-like n⁺-type GaN layer 23 is the one grown from five striped windows 22a. Also, the two striped window 12a of both sides in the 〈11-20〉 direction among these five striped windows 22a are zigzag shape as shown in Fig. 4, and serve to stop the lateral growth in the 〈11-20〉 direction of the n⁺-type GaN layer 23. Next, the growth pressure is increased to 80 kPa, for example, to promote growth in the vertical direction, and an n-type GaN layer 24 is grown upon the n⁺-type GaN layer 23 by an MOCVD method adjusting crystal growth conditions. The thickness of the n-type GaN layer 24 is, for example, 5 µm, the impurity concentration is, for example, 1 x 10¹⁶ cm⁻³. Thus, the distance in the 〈11-20〉 direction of the whole n⁺ type GaN layer 23 and the n-type GaN layer 24 after growing the n-type GaN layer 24 is, for example, about 5 µm. As shown in Fig. 12B, in the n⁺-type GaN layer 23 and the n-type GaN layer 24, threading dislocations 25 are formed at the directly above portion of the striped window 22a, and at the portion joined with the n⁺-type GaN layers 23 each other laterally grown from striped windows 22a adjacent to each other.

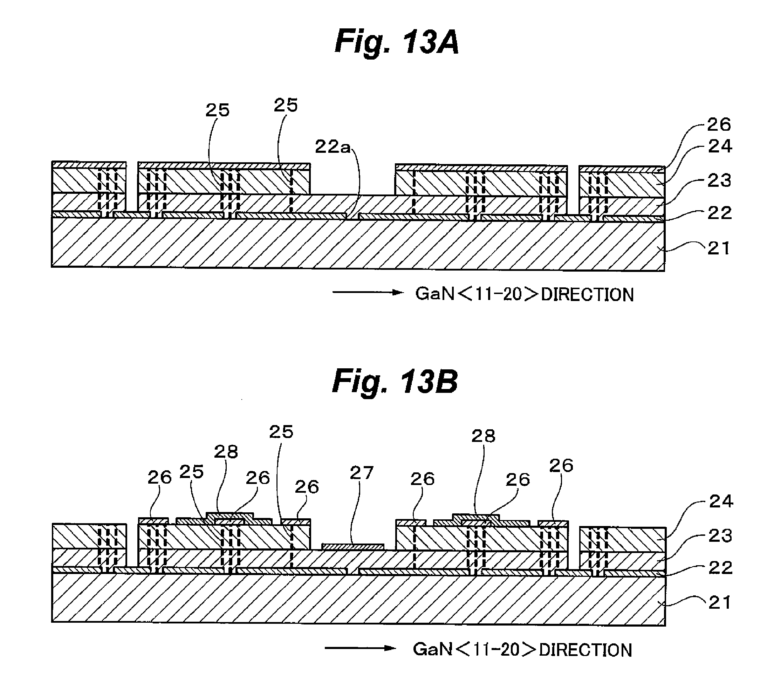

Next, as shown in Fig. 13A, for example, after forming an insulator film, for example, a 1-µm-thick SiO₂ film 26, upon the whole surface by a plasma CVD method, for example, the SiO₂ film 26 is patterned into a predetermined shape by photolithography and etching, the n-type GaN layer 24 is partially exposed. Next, using the SiO₂ film 26 patterned into the predetermined shape in this way as a mask, the n-type GaN layer 24 is etched and removed by an inductively coupled plasma (ICP)-reactive ion etching (RIE) using chlorine-based etching gas, for example, and the n⁺-type GaN layer 23 is exposed.

Next, as shown in Fig. 13B, for example, after forming an ohmic metal film upon the whole surface by, for example, a vacuum evaporation method, the ohmic metal film is patterned into a predetermined shape by photolithography and etching, and an ohmic electrode 27 is formed upon the exposed n⁺-type GaN layer 23. After this, an RTA (Rapid thermal annealing) is done at 800°C, for 30 seconds, for example, the ohmic electrode 27 is made an ohmic contact with the n⁺ type GaN layer 23. As the ohmic metal film, for example, a multilayer film of titanium(Ti)/aluminum (Al)/titanium(Ti)/gold(Au) in order from the bottom is used. The thickness of each film is, for example, a Ti film of the first layer is 10 nm, an Al film is 300 nm, a Ti film of the third layer is 30 nm, and an Au film is 500 nm.

Next, the SiO₂ film 26 is patterned into a predetermined shape by photolithography and etching, the n-type GaN layer 24 except the portion of the threading dislocations 25 is partially exposed. Next, a resist pattern (not illustrated) formed by photolithography remains as it is, for example, by a vacuum evaporation method, is formed a metal film for formation of a Schottky electrode upon the whole surface. After this, the resist pattern is removed together with the metal film for formation of a Schottky electrode formed upon the above (lift off). Thus, a Schottky electrode 28 is formed under the conditions contacting with the n-type GaN layer 24. As the metal film for formation of a Schottky electrode, for example, a double-layered film of nickel(Ni)/gold(Au) is used. The thickness of each film is, for example, a Ni film is 50 nm, and an Au film is 1000 nm. The Schottky electrode 28 is prevented from direct contact to the threading dislocation 25 by the SiO₂ film 26, current leak along the threading dislocations 25 can be prevented.

Next, as shown in Fig,14, a pad electrode 29 made of Au is formed upon the ohmic electrode 27, and a pad electrode 30 made of Au is formed upon the Schottky electrode 28.

After this, the base substrate 21 formed with a diode structure as described above is, for example, made into a chip in a manner such that the island-like n⁺-type GaN layer 23 and the n-type GaN layer 24 in one chip, for example, thereby an intended GaN-based Schottky diode is manufactured.

According to the second embodiment, in a GaN-based Schottky diode, the same advantages as the first embodiment can be obtained.

### The third embodiment

A GaN-based Schottky diode and the method for manufacturing thereof according to the third embodiment are explained.

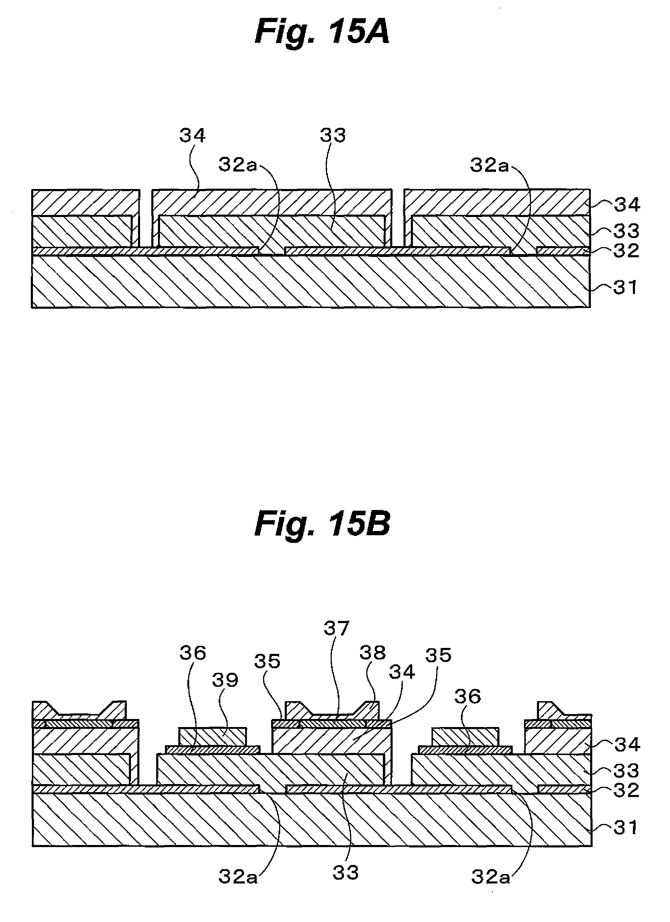

First, as the same as the first embodiment, as shown in Fig. 15A, a growth mask 32 is formed upon a base substrate 31. As the base substrate 31, a substrate grown a 2-µm-thick GaN layer upon a C-plane sapphire substrate is used. The growth mask 32 comprises a striped window 32a and an auxiliary striped window (not illustrated) as same as the growth mask 12. For example, the growth mask 32 is formed by a 0.3-µm-thick SiO₂ film, the length a of the striped window 32a is 1000 µm, the width b is 10 µm, the interval p₁ of the striped window 32a is 90 µm, the interval p₂ is 1010 µm, the width of a mask portion is 80 µm, the length c of the auxiliary striped window is 120 µm, the width d is 10 µm, the distance between the striped window 32a and the striped window 32a in the 〈1-100〉 direction is 10 µm, the overlapping length q of the end portion of the striped window 32a and the auxiliary striped window 32b is 55µm.

Next, using the growth mask 32, an n⁺-type GaN layer 33 doped with Si as n-type impurity is grown into an island shape in the (0001) plane orientation by an MOCVD method. The thickness of the n⁺-type GaN layer 33 is, for example, 10 µm, the impurity concentration is, for example, 5 x 10¹⁸cm⁻³. The distance between the n⁺-type GaN layer 33 and the n⁺-type GaN layer 33 is, for example, about 10µm. The growth of the n⁺-type GaN layer 33 is, for example, made at the temperature of 1100°C and the pressure of 30 kPa. At the growth of the n⁺-type GaN layer 33, for example, TMG and NH₃ are used as raw gas, H₂ and N₂ are used as carrier gas, SiH₄ diluted with nitrogen is used as n-type dopant. In this case, the island-like n⁺-type GaN layer 33 is grown from one striped window 32a. Next, adjusting crystal growth conditions to promote growth in vertical direction, an n-type GaN layer 34 is grown upon the n⁺-type GaN layer 33 by an MOCVD method. The thickness of the n-type GaN layer 34 is, for example, 5 µm, the impurity concentration is, for example, 1 x 10¹⁶cm⁻³. The distance in the whole 〈11-20〉 direction between the n⁺-type GaN layer 33 and the n-type GaN layer 34 after growing the n-type GaN layer 34 is, for example, about 5µm. In the n⁺-type GaN layer 33 and the n-type GaN layer 34, threading dislocations are formed at the directly above portion of the striped window 32a, but its illustration is omitted.

Next, after forming an insulator film upon the whole surface, for example, a 1-µm-thick SiO₂ film 35, for example by a plasma CVD method, the SiO₂ film 35 is patterned into a predetermined shape by photolithography and etching, and the n-type GaN layer 34 is partially exposed. Next, using the SiO₂ film 35 patterned into the predetermined shape in this way as a mask, the n-type GaN layer 34 is made edging removal by ICP-RIE using chlorine-based etching gas, for example, and as shown in Fig. 15B, the n⁺-type GaN layer 33 is exposed.

Next, after forming an ohmic metal film upon the whole surface by a vacuum evaporation method, for example, the ohmic metal film is patterned into a predetermined shape by photolithography and etching, and an ohmic electrode 36 is formed upon the exposed n⁺-type GaN layer 33. After this, for example, doing an RTA at 800°C for 30 seconds, the ohmic electrode 36 is made ohmic contact with the n⁺-type GaN layer 33. As the ohmic metal film, for example, a multilayer film of Ti/Al/Ti/Au in order from the bottom is used. Thickness of each film is, for example, a Ti film of the first layer is 10 nm, an Ai film is 300 nm, a Ti film of the third layer is 30 nm, and an Au film is 500 nm.

Next, the SiO₂ film 35 is patterned into a predetermined shape by photolithography and etching, and the n-type GaN layer 34 is partially exposed. Next, a resist pattern (not illustrated) formed by photolithography is remained as it is, a metal film for Schottky electrode formation is formed upon the whole surface, for example, by a vacuum evaporation method. After this, the resist pattern is removed together with the metal film for a Schottky electrode formation formed upon it (lift off) . In this way, a Schottky electrode 37 is formed under the conditions contacting with the n-type GaN layer 34. As the metal film for a Schottky electrode formation, for example, a double-layered film of Ni/Au is used. The thickness of each film, for example, a Ni film is 50 nm, and an Au film is 500 nm.

Next, a pad electrode 38 larger than the Schottky electrode 37 is formed upon the Schottky electrode 37, and a pad electrode 39 is formed upon the ohmic electrode 36.

After this, the base substrate 31 formed with a diode structure as described above is, for example, made into a chip in a manner such that the island-like n⁺-type GaN layer 33 and the n-type GaN layer 34 are included in one chip, and an intended GaN-based Schottky diode is manufactured.

According to the third embodiment, in the GaN-based Schottky diode, the same advantages as the first embodiment can be obtained.

### The fourth embodiment

A GaN-based Schottky diode and the method for manufacturing thereof according to the fourth embodiment are explained.

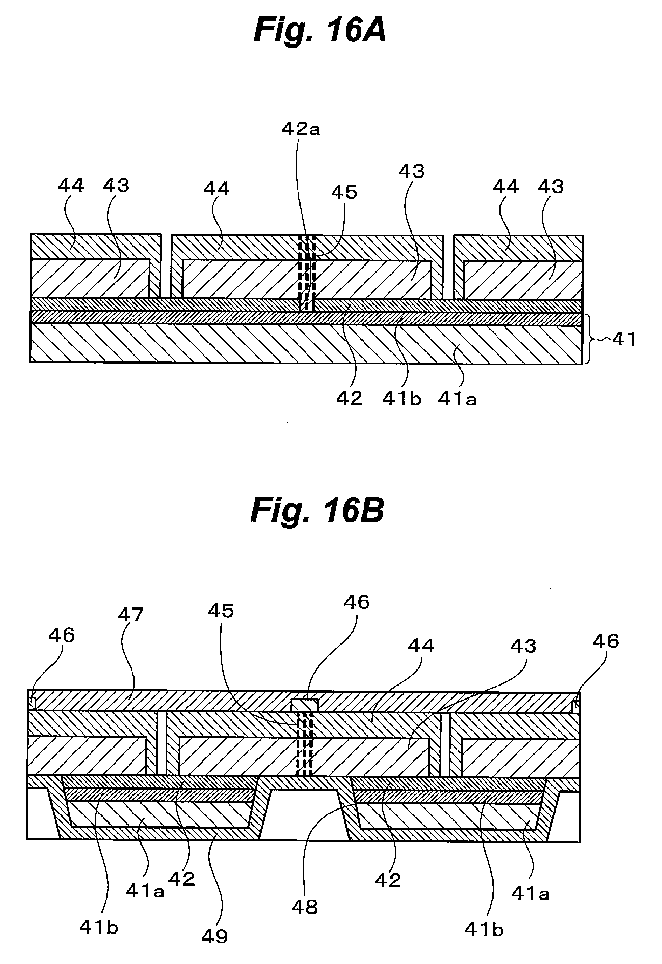

First, as shown in Fig. 16A, a growth mask 42 is formed as the same as the first embodiment upon a base substrate 41 grown an about 1-µm-thick AlN/GaN multilayer film 41b, for example, laminating a 5-nm-thick AlN film and a 20-µm-thick GaN film alternately upon a (111) plane-oriented Si substrate 41a. The growth mask 42 comprises the striped window 42a and an auxiliary striped window (not illustrated) as the same as the growth mask 12. For example, the growth mask 42 is formed with a 0.3-µm-thick SiO₂ film, the length a of the striped window 42a is 1000 µm, the width b is 10 µm, the interval p₁ of the striped window 42a is 90 µm, the interval p₂ is 1010 µm, the width of a mask portion is 80 µm, the length c of the auxiliary striped window is 120 µm, the width d is 10 µm, the distance between the striped window 42a and the striped window 42a in the 〈1-100〉 direction is 10 µm, and the overlapping length q of the end portion of the striped window 42a and the auxiliary striped window 42b is 55 µm.

Next, using the growth mask 42, an n⁺-type GaN layer 43 doped with Si as n-type impurity is grown into an island shape in the (0001) plane orientation by an MOCVD method. The thickness of the n⁺-type GaN layer 43 is, for example, 8 µm, the impurity concentration is, for example, 5 x 10¹⁸ cm⁻³. The distance between the n⁺-type GaN layer 43 and the n⁺-type GaN layer 43 is, for example, about 10 µm. The growth of the n⁺-type GaN layer 43 is, for example, made at the temperature of 1100°C and the pressure of 30 kPa. At the growth of the n⁺-type GaN layer 43 is, for example, TMG and NH₃ are used as raw gas, H₂ and N₂ are used as carrier gas, and SiH₄ diluted with nitrogen is used as an n-type dopant. In this case, one island-like n⁺-type GaN layer 43 is the one grown from one striped window 42a. Next, increasing a growth pressure, for example, to 80 kPa to promote the vertical direction growth, by an MOCVD method adjusting crystal growth conditions an n-type GaN layer 44 is grown upon the n⁺-type GaN layer 43. The thickness of the n-type GaN layer 44 is, for example, 5 µm, the impurity concentration is, for example, 1 x 10¹⁶ cm⁻³. The distance of the n⁺-type GaN layer 43 and the n-type GaN layer 44 as a whole in the 〈11-20〉 direction after growing the n-type GaN layer 44 in this way is, for example, about 5 µm. As shown in Fig. 16A, at the n⁺-type GaN layer 43 and the n-type GaN layer 44, threading dislocations 45 are formed at the directly above portion of the striped window 42a.

Next, as shown in Fig.16B, for example, after planarizing the surface by filling the gap between the n⁺-type GaN layer 43 and the n-type GaN layer 44 by applying organic SOG (Spin on glass) liquid (not illustrated), and for example, after forming, for example, an insulator film on the whole surface, for example, a 1-µm-thick SiO₂ film 46 by a plasma CVD method, for example, the SiO₂ film 46 is patterned into a predetermined shape by photolithography and etching, and only the SiO₂ film 46 of an upper portion of the threading dislocations 45 is left.

Next, for example, an upper electrode 47 as a Schottky electrode is formed by forming a metal film for a Schottky electrode formation upon the whole surface by, for example, a vacuum evaporation method. As the metal film for a Schottky electrode formation, for example, using a double-layered film of Ni/Au. The thickness of each film is, for example, an Ni film is 50 nm, and an Au film is 500 nm.

Next, after the Si substrate 41a of the base substrate 41 is thinned to the thickness of, for example, about 50 to 100 µm by polishing, etc. from the back side, for example, a striped via hole 48 having about 20µm-width is formed upon the Si substrate 41a of the portion corresponding to the striped window 42a of the grow mask 42, and the AlN/GaN multilayer film 41b of the bottom of the via hole 48 is exposed.

Next, through the via hole 48, the AlN/GaN multilayer film 41b is removed by, for example, plasma etching using chlorine-based etching gas, continuously through the via hole 48, the growth mask 42 is etched and removed, and the n⁺-type GaN layer 43 is exposed.

Next, a bottom electrode 49 is formed by forming an ohmic metal film by, from the back side of the Si substrate 41a by, for example, a vacuum evaporation method. As the ohmic metal film, for example, a Ti/Al/NiAu multilayer film is used.

After this, the base substrate 41 formed a diode structure as described above is made into a chip in a manner such that one island-like n⁺-type GaN layer 43 and n-type GaN layer 44 are included in one chip, and an intended GaN-based Schottky diode is manufactured.

As necessary, the inside of the via hole 48 is fully filled by plating, for example, Au, Cu, etc., then after the surface of the back side of the Si substrate 41a is flattened, the bottom electrode 49 may be formed. As described, by filling the inside of the via hole 48 with Au, Cu, etc., the heat conductivity can be improved, and temperature rise due to generation of heat during operation of the GaN-based Schottky diode can be suppressed

According to the fourth embodiment, in the GaN-based Schottky diode, the same advantages as the first embodiment can be obtained.

### The fifth embodiment

A GaN-based MIS (metal-insulator-semiconductor) field effect transistor (FET) and the method for manufacturing thereof according to the fifth embodiment are explained.

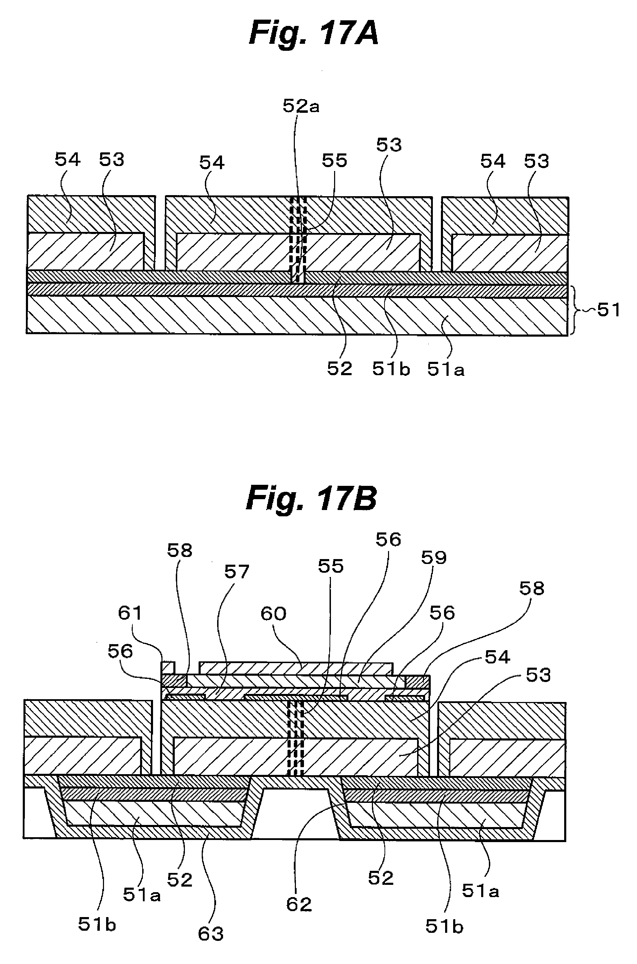

First, as shown in Fig. 17A, a growth mask 52 is formed as the same as the first embodiment upon a base substrate 51 grown, for example, an about 1-µm-thick AlN/GaN multilayer film 51b laminating, for example, an about 5-nm-thick AlN film and a 20-nm-thick GaN film alternately upon a (111) plane-oriented Si substrate 51a. The growth mask 52 comprises a striped window 52a and an auxiliary striped window (not illustrated) as the same as the growth mask 12. For example, the growth mask 52 is formed with a 0.3-µm-thick SiO₂ film, the length a of the striped window 52a is 1000 µm, the width b is 10 µm, the interval p₁ of the striped window 52a is 90 µm, the interval p₂ is 1010 µm, the width of a mask portion is 80µm, the length c of the auxiliary striped window is 120µm, the width d is 10µm, the distance between the striped window 52a and the striped window 52a in the 〈1-100〉 direction is 10µm, the length q of overlapping portion of the end portion of the striped window 52a and the auxiliary striped window 52b is 55 µm.

Next, using the growth mask 52, an n⁺-type GaN layer 53 doped with Si as an n-type impurity is grown into an island-like shape in the (0001) plane orientation by an MOCVD method. The thickness of the n⁺-type GaN layer 53 is, for example, 8 µm, the impurity concentration is, for example, 5 x 10¹⁸ cm⁻³. The distance between the n⁺-type GaN layer 53 and the n⁺-type GaN layer 53 is, for example, about 10 µm. The growth of the n⁺-type GaN layer 53 is made, for example, at the temperature of 1100°C, and the pressure of 30 kPa. At the growth of the n⁺-type GaN layer 53, for example, TMG and NH₃ are used as raw gas, H₂ and N₂ are used as carrier gas, and SiH₄ diluted with nitrogen is used as an n-type dopant. In this case, one island-like n⁺-type GaN layer 53 is the one grown from one striped window 52a. Next, in order to promote the growth in the vertical direction, increasing the growth pressure to, for example, 80 kPa, and adjusting the crystal growth conditions, the n-type GaN layer 54 is grown upon the n⁺-type GaN layer 53 by an MOCVD method. The thickness of the n-type GaN layer 54 is, for example, 5 µm, the impurity concentration is, for example, 1 x 10¹⁶ cm⁻³. After growing the n-type GaN-based semiconductor layer 54 in this way, the distance between the n⁺-type GaN layer 53 and the n-type GaN layer 54 as a whole in the 〈11-20〉 direction is, for example, 5 µm.

Next, as shown in Fig. 17B, following the growth of the n-type GaN layer 54, after growing an p⁺-type GaN layer 56 doped with magnesium (Mg) as a p-type impurity, for example, upon the whole surface, the p⁺-type GaN layer 56 is patterned into a predetermined shape by photolithography and etching. The thickness of the p⁺-type GaN layer 56 is, for example, about 500 nm, the impurity concentration is, for example, 5 x 10¹⁹ cm⁻³. The growth of the p⁺-type GaN layer 56, for example, is made at the temperature of 1100°C, and the pressure of 30 kPa. At the growth of the p⁺-type GaN layer 56, for example, TMG and NH₃ are used as raw gas, and H₂ and N₂ are used as carrier gas, and bis (cyclopentadienyl) magnesium (Cp₂Mg) is used as p-type dopant. The etching of the p⁺-type GaN layer 56 is made by, for example, ICP-RIE using chlorine-based etching gas.

Next, for example, by an MOCVD method, an n-type GaN layer 57 doped with Si as an n-type impurity is grown upon the whole surface to cover the p⁺-type GaN layer 56 patterned in the predetermined shape, and continuously the n⁺-type GaN layer 58 doped with Si as an n-type impurity is grown. The thickness of the n-type GaN layer 57 is, for example, 1000 nm, the impurity concentration is, for example, 1 x 10¹⁷ cm⁻³, the thickness of the n⁺-type GaN layer 58 is, for example, 100 nm, the impurity concentration is, for example, 5 x 10¹⁸ cm⁻³.

Next, after patterning the n-type GaN layer 57 and the n⁺-type GaN layer 58 in a predetermined shape by photolithography and etching, a portion of the n⁺-type GaN layer 58 is removed by photolithography and etching. The etching is made by, for example, ICP-RIE using chlorine-based gas.

Next, after forming an insulator film of, for example, a SiO₂ film and a SiN film, etc. upon the whole surface by, for example, a plasma CVD method, the insulator film is patterned into a predetermined shape by photolithography and etching, and a gate insulator film 59 is formed upon the n-type GaN layer 57. The thickness of the gate insulator film 59 is, for example, about 50 nm.

Next, after forming a Ni film upon the whole surface by, for example, a vacuum evaporation method, the Ni film is patterned into a predetermined shape by photolithography and etching, thereby a gate electrode 60 is formed upon the gate insulator film 59.

Next, after forming a Ti/Al/Au multilayer film upon the whole surface by, for example, a vacuum evaporation method, the Ti/Al/Au multilayer film is patterned into a predetermined shape by, for example, photolithography and etching, thereby a source electrode 61 is formed upon the n⁺-type GaN layer 58.

Next, after thinning the Si substrate 51a of the base substrate 51 to, for example, about 50 to 100 µm in thickness by polishing, etc. from the back side, for example, a striped via hole 62 having about 20µm width is formed in the Si substrate 51a of a portion corresponding to the striped window 52a of the growth mask 52, and an AlN/GaN multilayer film 51b is exposed upon the bottom of the via hole 62.

Next, through the via hole 62, a AlN/GaN multilayer film 51b is removed by, for example, a plasma etching using, for example, chlorine-based etching gas, continuously through the via hole 62, the growth mask 52 is etched and removed, and the n⁺-type GaN layer 53 is exposed.

Next, from the back side of the base substrate 51, a drain electrode 63 is formed by forming an ohmic metal film by, for example, a vacuum evaporation method. As the ohmic metal film, for example, a Ti/Al/NiAu multilayer film is used.

By the above, an intended GaN-based MISFET is manufactured.

As necessary, the n⁺-type GaN layer 58 can be replaced with, for example, an n-type AlGaN layer or a nondoped AlGaN layer.

Also, as necessary, after flattening the surface of the back side of the base substrate 51 by completely filling the inside of the via hole 62 with, for example, plating of Au, Cu, etc., the drain electrode 63 may be formed. By filling the inside of the via hole 62 with Au, Cu, etc. heat conductivity can be improved, and the temperature rise due to generation of heat during operation of the GaN-based MISFET can be suppressed.

The operation of the GaN-based MISFET is explained.

In the GaN-basedMISFET, the n⁺-type GaN layer 58 serves as a source region, the n⁺-type GaN layer 53 serves as a drain region, the n-type GaN layers 54 and 57 serve as a channel region. At the bottom portion of the n-type GaN layer 57 as the channel region, the p⁺-type GaN layer 56 with high impurity concentration is disposed. Just under the end portion of the gate electrode 60 on the side of the source electrode 61, the n⁺-type GaN layer 58 is not formed, therefore, a depletion layer caused by the p⁺-type GaN layer 56 spreads over the n-type GaN layer 57 as the channel region. For this, the GaN-based MISFET is a normally-off structure. By applying plus (+) bias voltage upon the gate electrode 60, electrons are induced in the n-type GaN layer 57 adjacent to the interface with the gate insulator film 59 just under the gate electrode 60, as the result, a channel is formed between the source electrode 61 and the drain electrode 63, the GaN-based MISFET becomes on-state, and electric current flows between the source electrode 61 and the drain electrode 63. In the GaN-based MISFET, by high energy barrier that the p⁺-type GaN layer 56 has, a high drain breakdown voltage can be obtained. Also, as the n⁺-type GaN layer 58 with high impurity concentration forms a source region, a source resistance can be reduced. Also, although the thickness of the n-type GaN layer 54 under the p⁺-type GaN layer 56 is as thin as about 5 µm, the breakdown voltage of GaN is large enough as 300V/µm, thereby high drain breakdown voltage can be obtained.

According to the fifth embodiment, in a GaN-based MISFET, the same advantages as the first embodiment can be obtained.

### The sixth embodiment

According to the sixth embodiment, in the method for manufacturing a GaN-based Schottky diode according to the third embodiment, especially, a case using a C-plane sapphire substrate as a base substrate 31 is explained.

First, as the same as the third embodiment, as shown in Fig. 15A, the growth mask 32 is formed directly upon the C-plane sapphire substrate as the base substrate 31.

Next, the C-plane sapphire substrate forming the growth mask 32 in this way is brought into an MOCVD equipment, for example, by being kept in a carrier gas made of mixed gas of H₂ and N₂, for five minutes at 1100°C, thereby the surface cleaning is made.

Next, for example, after lowering temperature to 550°C, providing NH₃ and TMG, an about 30-nm-thick amorphous GaN layer is grown.

Next, while flowing NH₃, rising the temperature to 1150°C, and after keeping the temperature for 10 minutes, providing TMG and SiH₄ at the temperature of 1050 to 1100°C, for example, the n⁺-type GaN later 33 and the n-type GaN layer 34 are grown. By doing so, the island-like n⁺-type GaN layer 33 and the n-type GaN layer 34 can be grown.

The after processes are the same as the third embodiment.

According to the six embodiment, in addition to the same advantages according to the third embodiment, as a C-plane sapphire substrate itself can be used as the base substrate 31, a GaN layer is not necessary to grow upon the C-plane sapphire substrate, thereby the manufacturing process of the GaN-based Schottky diode can be simplified for that, and another advantage can be obtained that the manufacturing cost of the GaN-based Schottky diode can be reduced.

### The seventh embodiment

A method for manufacturing a GaN-based semiconductor device according to the seventh embodiment is explained.

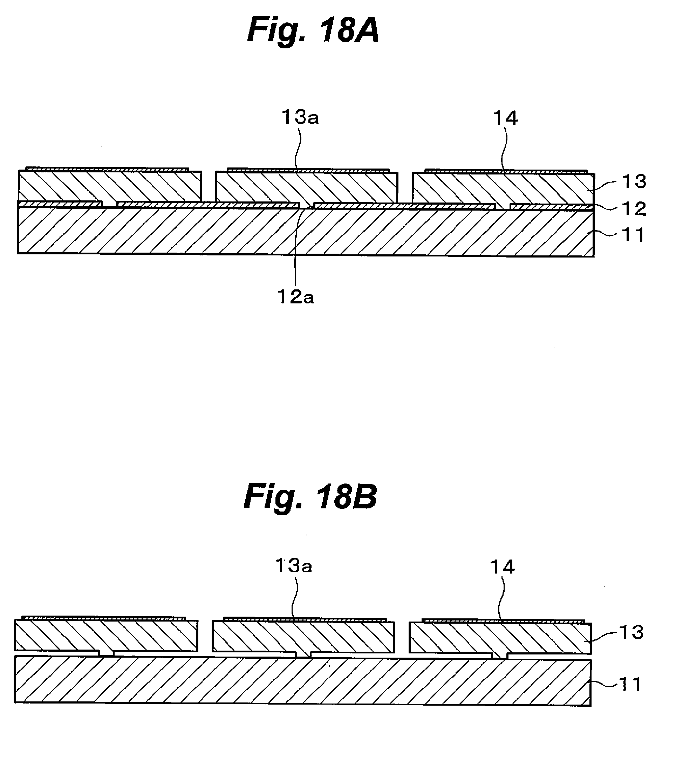

In the seventh embodiment, as the same as the first embodiment, as shown in Fig. 18A, after growing the GaN-based semiconductor layer 13 to an island shape in the (0001) plane orientation upon the base substrate 11 using the growth mask 12 shown in Fig. 3. the necessary first electrode 14 is formed upon a upper surface (hereafter refer to "the first plane 13a") of the GaN-based semiconductor layer 13. The materials of the first electrode 14 and the formation method of the first electrode 14 are selected as necessary. The materials of the first electrode 14 is appropriately selected whether the first electrode 14 is an ohmic electrode or a Schottky electrode, or the conductivity type of the top layer of the GaN-based semiconductor layer 13 that the first electrode 14 contacts. Particularly, as the first electrode 14, for example, a multilayer film of Ni/Au/Ni in order from the bottom is used. The thickness of each layer is, for example, an Ni film of the first layer is 5 nm, an Au film is 500 nm, and a Ni film of the second layer is 100 nm. Also, the first electrode 14 is formed, for example, by forming a metal film or an alloy film for formation of the first electrode 14 upon the whole surface by, for example, a vacuum evaporation method or a sputtering method, and thereafter by patterning these metal films or alloy filmst into a predetermined shape by photolithography and etching. In Fig. 18A, the first electrode 14 is formed upon a portion except a peripheral portion of the first plane 13a of the GaN-based semiconductor layer 13, for example, an inside portion apart from 6 µm or more from the brim, but may be formed upon the whole surface of the first plane 13a of the GaN-based semiconductor layer 13.

Next, as shown in Fig. 18B, the growth mask 12 is removed by a wet etching, etc. For example, in case the growth mask 12 is made of a SiO₂ film, the growth mask is removed by a wet etching using buffered hydrofluoric acid. The removal of the growth mask 12 is not essential, but is effective to improve the yield of separation of the GaN-based semiconductor layer 13, which is described later.

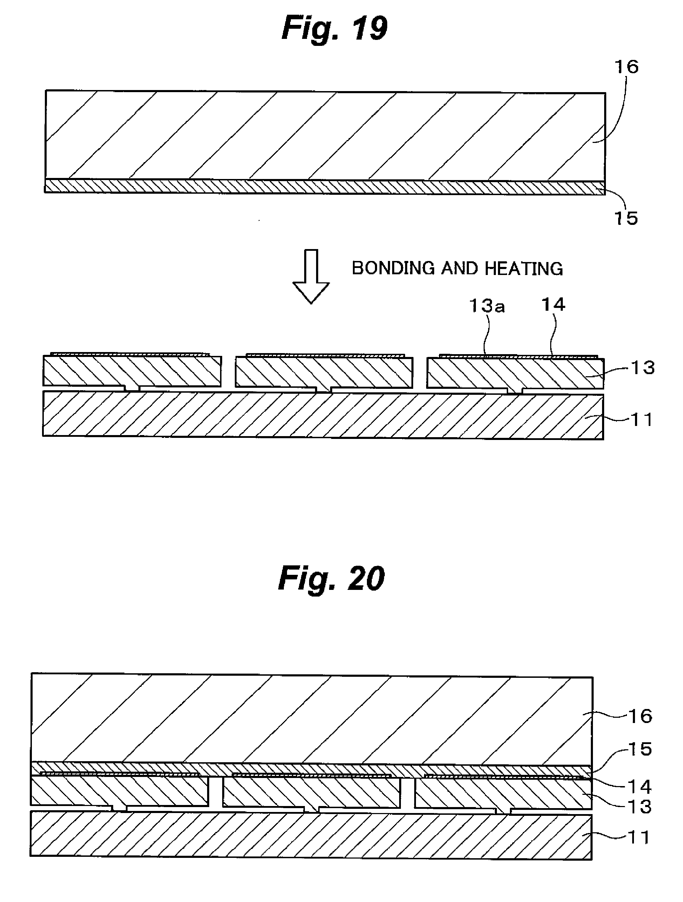

Next, as shown in Fig. 19, preparing the first support substrate 16 formed a metal for bonding 15 upon a major surface, the metal for bonding 15 of the first support substrate 16 is opposed with the first electrode 14 formed upon the first plane 13a of the GaN-based semiconductor layer 13 upon the base substrate 11. As the metal for bonding 15, solder can be used, more particularly, for example, an Au/Sn solder thin film is used. Also, as the first support substrate 16, for example, substrates made of elemental semiconductors such as si, etc., compound semiconductors such as SiC, GaAs, GaP, AlN, GaN, ZnO, etc., various metals, alloys, nitride-based ceramics, oxide-based ceramics, diamonds, carbons, plastics, etc. can be used, and is selected as necessary. The typical example of the first support substrate 16 is a Si substrate.

Next, as shown in Fig. 20, the metal for bonding 15 of the first support substrate 16 is made contact with the first electrode 14 formed upon the GaN-based semiconductor layer 13 upon the base substrate 11, and is bonded with the first electrode 14 by melting the metal for bonding 15 by heating under the conditions. In this way, the first support substrate 16 is bonded to the first electrode 14 formed upon the first plane 13a of the GaN-based semiconductor layer 13 upon the base substrate 11. For example, as the metal for bonding 15, an Au/Sn solder thin film is used, and in case the first electrode 14 is made of the multilayer metal film made of a Ni film, Au film and the above Ni film, the metal for bonding 15 of the first support substrate 16 is made contact with the first electrode 14, and by heating at about 250°C under the conditions, making the metal for bonding 15 melt, bonding with the first electrode 14, then the first support substrate 16 is bonded to the first electrode 14.

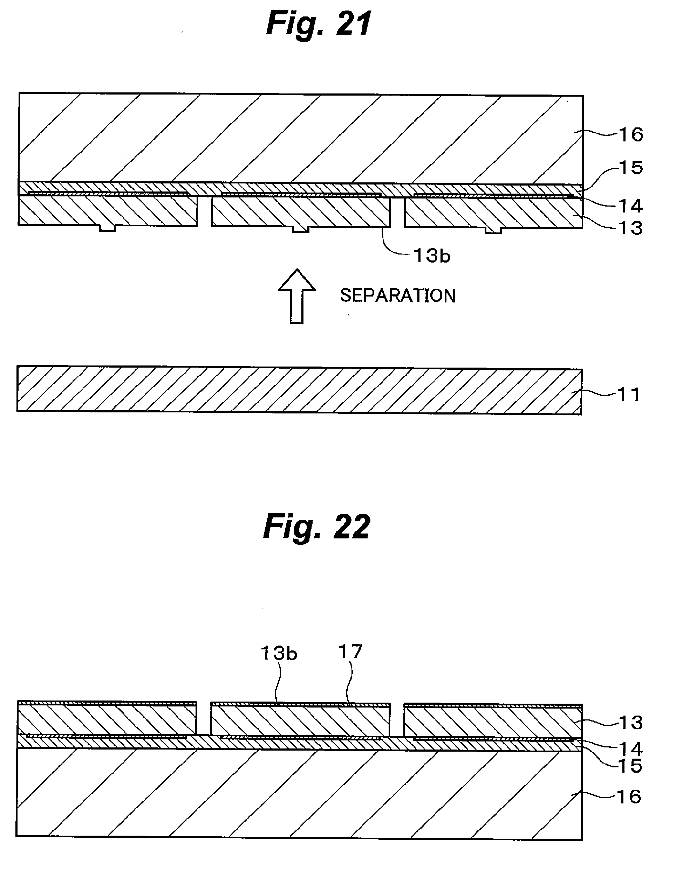

Next, as shown in Fig. 21, the base substrate 11 and the first support substrate 16 joined together by bonding as described above are peeled off between the base substrate 11 and the GaN-based semiconductor layer 13. Particularly, for example, by applying ultrasonic wave and stimulating the joined base substrate 11 and the first support substrate 16, they are peeled off between the base substrate 11 and the GaN-based semiconductor layer 13. Or, by applying mechanical force and stimulating a portion of the end portion of the joined base substrate 11 and the first support substrate 16 together, the base substrate 11 and the first support substrate 16 may be peeled off between the base substrate 11 and the GaN-based semiconductor layer 13. The plane of the GaN-based semiconductor layer 13 exposed by peeling off between the base substrate 11 and the GaN-based semiconductor layer 13 off in this way is named the second plane 13b.

Next, as shown in Fig. 22, the necessary second electrode 17 is formed upon the second plane 13b of the GaN-based semiconductor layer 13. The materials of the second electrode 17 and a formation method of the second electrode 17 are selected as necessary. The materials of the second electrode 17 is appropriately selected by whether the second electrode 17 is an ohmic electrode or a Schottky electrode, or depending on the conductivity type of the uppermost layer of the GaN-based semiconductor layer 13 that the second electrode 17 contacts. Particularly, as the second electrode 17, for example, a multilayer film of Ti/Al/Au in order from the bottom is used. Thickness of each film is, for example, a Ti film is 5 nm, an Al film is 45 nm, and Au film is 10 nm. Also, the second electrode 17 is formed, for example, by forming a metal film or an alloy film for formation of the second electrode 17 upon the whole surface by a vacuum deposition method or a sputtering method, and thereafter by patterning these metal films or alloy films into a predetermined shape by photolithography and etching. In the Fig 22, the second electrode 17 is formed upon the whole surface of the second plane 13b of the GaN-based semiconductor layer 13, but may be formed upon the portion except the peripheral portion of the second plane 13b of the GaN-based semiconductor layer 13, for example, the inside portion apart from 6 µm or more from the brim. In case the second electrode 17 is an ohmic electrode, as necessary, after forming the second electrode 17 upon the second plane 13b of the GaN-based semiconductor layer 13, by executing laser annealing by irradiating laser beam upon the second electrode 17, the second electrode 17 can be made an ohmic contact for the GaN-based semiconductor layer 13 with lower resistance. For example, in case the second electrode 17 is made of a multilayer metal film of a Ti film, an Al film and an Au film of which total thickness is 50 nm, by using laser beams with wavelength of 266 nm, the light transmittance of the multilayer metal film is low about 20 %, and the laser beam is fully absorbed, therefore the interface between the GaN-based semiconductor layer 13 and the second electrode 17 can be fully heated up, and enough laser annealing can be made.

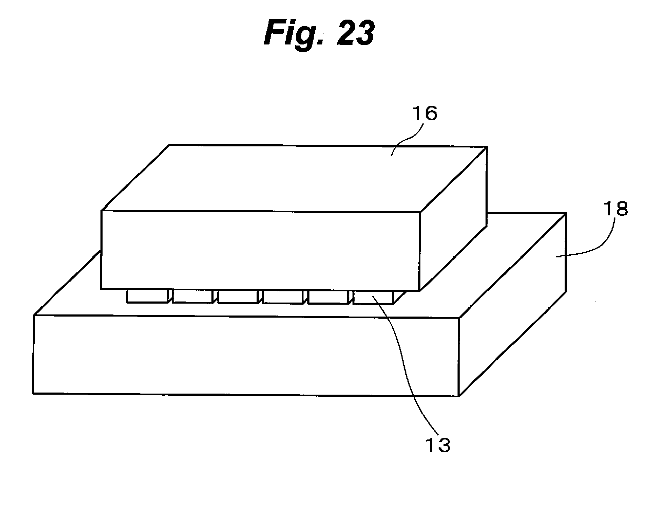

Next, as shown in Fig. 23, preparing the second support substrate 18 formed a metal for bonding (not illustrated) on one major surface, the metal for bonding of the second support substrate 18 makes contact with the second electrode 17 formed upon the second plane 13b of the GaN-based semiconductor layer 13 upon the first support substrate 16, and under the conditions, melting the metal for bonding by heating, being bonded with the econd electrode 17. In this way, the second support substrate 18 is bonded with the second electrode 17 formed upon the second plane 13b of the GaN-based semiconductor layer 13 upon the first support substrate 16. For example, using anAn/Sn solder thin film as the metal for bonding, in case the second electrode 14 is made of a multilayer metal film made of an Ni film, an Au film and the above Ni film, after the adhesive metal of the second support substrate 18 makes contact with the second electrode 17, and under the conditions, by heating at about 250°C, melting an adhesive metal, and bonding with the second electrode 17 and the second support substrate 18 is bonded to the second electrode 17. Solder can be used as the metal for bonding, more practically, for example, an Au/Sn solder thin film is used. Also, as the second support substrate 18, as the same as the first support substrate 16, for example, elemental semiconductors such as Si, etc., compound semiconductors such as SiC, GaAs, GaP, AlN, GaN, ZnO, etc., various metals, alloys, nitride-based ceramics, oxide-based ceramics, diamonds, carbons, plastic, etc. can be used, and is selected as necessary. Among them, for example, metals such as Cu, etc. or alloys which have good heat radiation performance, is preferably used. The typical example of the second support substrate 18 is, a Cu plate (the thickness is, for example, 1 mm) formed an Au plating and an Au/Sn solder thin film, or an AlN ceramic substrate formed metal lines.

By the above, as shown in Fig. 23, a two-terminal GaN-based semiconductor device formed the first electrode 14 upon the first plane 13a, and the second electrode 17 upon the second plane 13b of the GaN-based semiconductor layer 13, specifically, a GaN-based diode is formed by sandwiching between the first support substrate 16 and the second support substrate 18. The first electrode 14 and the second electrode 17 are an anode or a cathode. The GaN-based diode is a p-n junction diode or a Schottky diode, and in the p-n junction diode, both the first electrode 14 and the second electrode 17 are ohmic electrodes, in the Schottky diode, either of the first electrode 14 and the second electrode 17 is a Schottky electrode, and the other is an ohmic electrode. The distance between the first support substrate 16 and the second support substrate 18 is, for example, about 20 µm.

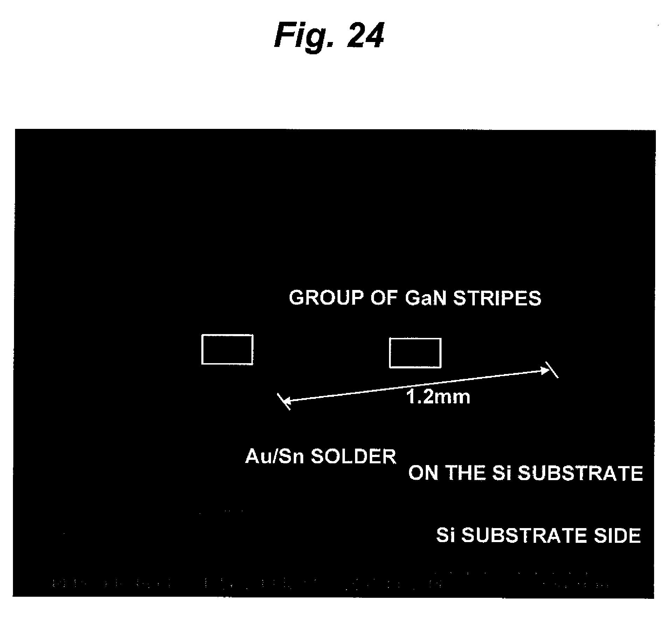

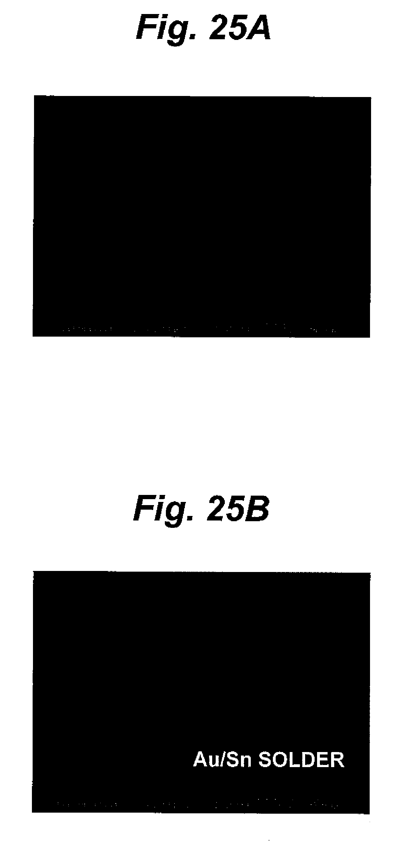

An example of a SEM image of the surface of the GaN-based semiconductor layer 13 side upon the first support substrate 16 after peeling the base substrate 11 off is shown in Fig. 24. Here, as the base substrate 11, a C-plane sapphire substrate grown a 2-µm-thick GaN layer grown is used. As the GaN-based semiconductor layer 13, a GaN layer is grown. As the growth mask 12, the one having the same pattern as shown in Fig. 3 is used. The growth mask 12 is formed by a 0.3-µm-thick SiO₂ film formed by a plasma CVD method, the length a of the striped window 12a is 1200 µm, the width b is 5 µm, the interval p₁ of the striped window 12a is 85 µm, the width of a mask portion 12c is 80 µm, the overlapping length r at the end portions each other of striped windows 12a is 65 µm. As the first support substrate 16, a Si substrate is used, and upon that, an Au/Sn solder thin film is formed as the metal for bonding 15. At the growth of the GaN layer, first, upon the base substrate 11 formed the growth mask 12 , a low temperature GaN buffer layer(not illustrated) is grown by a conventional publicly-known technique. Particularly, by an MOCVD method, using TMG and NH₃ as raw gas, using H₂ and N₂ as carrier gas, a 30-nm-thick low temperature GaN buffer layer is grown at the temperature of 530°C. After this, stopping the supply of TMG, for example, after rising temperature to 1150°C, providing TMG again, GaN is grown at the pressure of 30 kPa. In this way, a GaN layer is grown into an island-like shape. The thickness of the GaN layer is 15 µm. As shown in Fig. 24, a group of striped island-like GaN layers appearing by peeling is seen. The enlarged illustration of the end portion of striped island-like GaN layers in Fig. 24 is shown in Fig. 25A, and the enlarged illustration of the center portion of the island-like GaN layers is shown in Fig. 25B.

The width b of the striped window 12a of the growth mask 12 shown in Fig. 3, and the width of the mask portion 12c are both changed in various sizes, and the result of the measure of peeling the GaN-based semiconductor layer 13 from the base substrate 11 is explained. The growth mask 12 is formed by a 0.3-µm-thick SiO₂ film formed by a plasma CVD method. The base substrate 11, the GaN-based semiconductor layer 13, the growth conditions of the GaN-based semiconductor layer 13, and the first support substrate 16, and the metal for bonding 15 are the same as the samples shown in Fig. 24. The first plane 13a of the GaN layer as the GaN-based semiconductor layer 13 is formed a multilayer film of Ni/Au/Ni (the thickness of each film is an Ni film of the first layer is 5 nm, an Au film is 500 nm, an Ni film of the second layer is 100 nm) as the first electrode 14. The distance between the striped GaN layer as the GaN-based semiconductor layer 13 and the adjacent striped GaN layer is to be about 5 to 8 µm. When the interval p₁ is 10 µm or less, the GaN layers adjacent to each other coalesce easily, therefore to prevent the coalescence, a portion shown in Fig. 5 is formed in the growth mask 12. The width b of the striped window 12a is changed to five levels of 1 µm, 3 µm, 5 µm, 10 µm, 20 µm, and the width of the mask portion 12c is changed to six levels of 3 µm, 5 µm, 10 µm, 50 µm, 80 µm, 100 µm.

Counting the number of striped GaN layers peeled from a sapphire substrate as the base substrate 11, the ratio for the total number is measured. The result is shown in Table 1. The slanted lines in the Table 1 show the portions which are not carried out experiments.

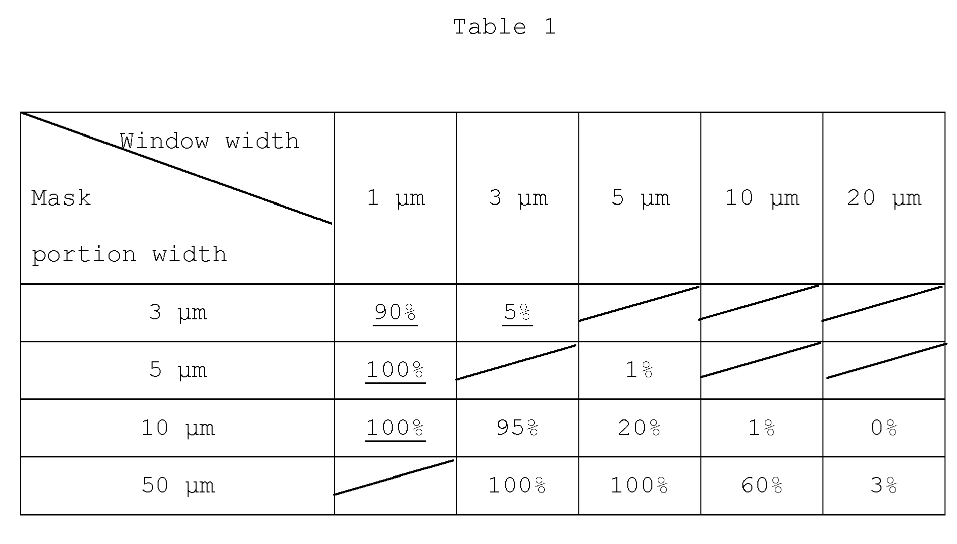

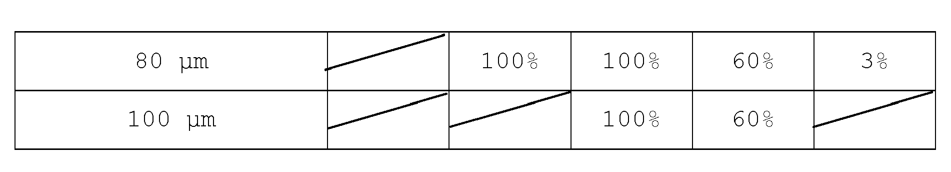

From Table 1, it is known that when the width b of the striped window 12a is 20 µm, the GaN layer cannot be peeled mostly. The reason is considered that when the adhesion strength and the width b of a Ni/Au/Ni multilayer film as the first electrode 14 for the first plane 13a of a GaN layer are compared with the adhesion strength of the sapphire substrate and a GaN layer in a 20-µm-width striped window 12a, the latter is stronger than the former. The width of a striped GaN layer is practically about 150 µm or less, the width b of the striped window 12a is said to be preferably 20 µm or less. Also, by Table 1, when the width of the mask portion 12c is smaller than the width b of the striped window 12a, it is known that a GaN layer cannot be peeled off. By this, it is said that in the growth mask 12 (a width b of the striped window 12a/a width of the mask portion 12c) is preferably ≦ 1.

According to the seventh embodiment, in addition to the same advantages as the first embodiment, the following various advantages can be obtained. That is, the first support substrate 16 is bonded to the first plane 13a of the GaN-based semiconductor layer 13 grown upon the base substrate 11, the first support substrate 16 and the GaN-based semiconductor layer 13 are peeled off from the base substrate 11, after that, the second support substrate 18 is bonded to the second plane 13b of the GaN-based semiconductor layer 13. For this, for example, by using a high thermal conductive substrate as the second support substrate 18, heat radiation performance of a two-terminal GaN-based semiconductor device sandwiched between the first support substrate 16 and the second support substrate 18 can be significantly improved, thereby the two-terminal GaN-based semiconductor device with high heat radiation performance can be realized.

Also, according to the seventh embodiment, it is not necessary to use a conventionally used laser lift technique as a peeling method of a sapphire substrate after growing a GaN-based semiconductor layer upon a sapphire substrate, therefore, there are no various problems when using a laser lift-off technique. That is, in the laser lift-off technique, laser beam of 266-nm wavelength oscillating by a pulse high output laser is irradiated from the sapphire substrate side, by the absorption of a GaN-based semiconductor layer from the interface between a sapphire substrate and a GaN-based semiconductor layer to a few hundred nm depth, the temperature of the portions rapidly risen to high temperature makes thermal decomposition, and by the pressure of generated nitrogen (N₂) gas, the sapphire substrate is peeled off at the interface between the sapphire substrate and the GaN-based semiconductor layer. The laser lift-off technique is effective to partially peeling a sapphire substrate, however there are some drawbacks to the pressure control of generated nitrogen gas, therefore, when peeling a sapphire substrate off for a large area, the pressure of peeling becomes uneven in-plain of a sapphire substrate, by uneven pushing up effect by local pressure rise, cracks are generated or destruction is occurred in the GaN-based semiconductor layer. For this, it is difficult to peel off the sapphire substrate for the whole irradiated area by laser beam, while keeping the GaN-based semiconductor layer undamaged. For this, according to the seventh embodiment, as the base substrate 11 such as a sapphire substrate, etc. can be easily peeled off over the whole surface of the base substrate 11 from the GaN-based semiconductor layer 13, keeping the GaN-based semiconductor layer 13 undamaged, therefore there are no such problems. Also, in the laser lift-off technique, it is necessary to use a high-priced pulse high output laser, for this, according to the seventh embodiment, it is not necessary to use such a pulse high output laser, thereby manufacturing cost of the GaN-based semiconductor device can be reduced.

### The eighth embodiment

Amethod for manufacturing of a vertical conductive type GaN-based Schottky diode according to the eighth embodiment is explained.

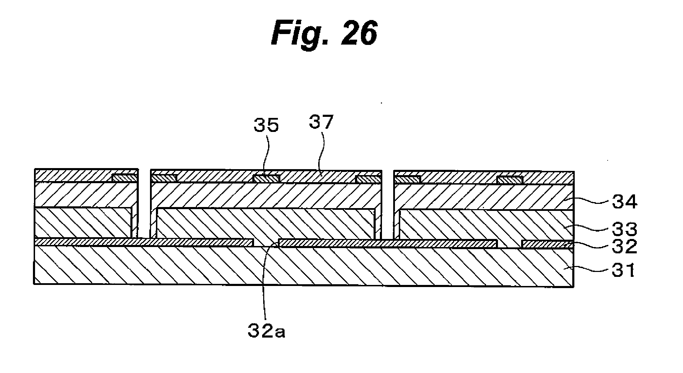

First, as shown in Fig. 26, a growth mask 32 similar to the growth mask 12 shown in Fig. 3 is formed upon a base substrate 31.

Next, using the growth mask 32, an n⁺-type GaN layer 33 doped with Si as an n-type impurity is grown into an island-like shape in the (0001) plane orientation by an MOCVD method. In this case, one island-like n⁺-type GaN layer 33 is grown from one striped window 32a. The distance between the n⁺-type GaN layer 33 and the n⁺-type GaN layer 33 is, for example, about 10 µm. The growth of the n⁺-type GaN layer 33 is, for example, is made at the temperature of 1100°C, and the pressure of 30 kPa in which the growth mode in the lateral direction becomes dominant. At the growth of the n⁺-type GaN layer 33, for example, TMG and NH₃ are used as raw gas, H₂ and N₂ are used as carrier gas, and SiH₄ diluted with nitrogen is used as an n-type dopant. Controlling the supply condition (for example, the ratio of the supply amount of TMG and the supply amount of NH₃) of raw gas, for example, for the width of 70 µm of the n⁺-type GaN layer 33, the thickness of the n⁺-type GaN layer 33 makes about 15 µm. The impurity concentration of the n⁺-type GaN layer 33 is, for example, to be 1 x 10¹⁸cm⁻³.

Next, reducing the supply amount of SiH₄, further making the growth pressure 60 kPa, and increasing the supply amount of TMG, for example, to two-hold, the n-type GaN layer 34 is grown upon the n⁺-type GaN layer 33 by an MOCVD method with a growth condition that the vertical direction growth becomes dominant. The thickness of the n-type GaN layer 34 is, for example, 5 µm, and the impurity concentration is, for example, 3 x 10¹⁶cm⁻³. By this, the pendent distance of the n-type GaN layer 34 in a lateral direction from the side of the n⁺-type GaN layer 33 after growing the n-type GaN layer 34 is about 4 µm upon one side. In the n⁺-type GaN layer 33 and the n-type GaN layer 34, threading dislocations are formed at the directly above portion of the striped window 32a.

Next, after forming an insulator film, for example, a 1-µm-thick SiO₂ film 35, upon the whole surface by a plasma CVD method, the SiO₂ film 35 is patterned into a predetermined shape by photolithography and etching, a striped SiO₂ film 35 is formed at the peripheral portion of the coverage of about 5 µm from the side of the n-type GaN layer 34 upon the n-type GaN layer 34 and a portion with 8 µm in width of directly above portion of the striped window 32a. The SiO₂ film 35 is disposed to play a role as a field plate to relax concentration of electric field at the end portion of the Schottky electrode 37 which is explained later.

Next, after forming a metal film for a Schottky electrode formation upon the whole surface by, for example, a vacuum evaporation method, the metal film is patterned into a predetermined shape by photolithography or etching. As the metal film, a multilayer film of Ni/Au/Ni/Au (the thickness of each film is that an Ni film of the first layer is 20 nm, an Au film of the first layer is 100 nm, an Ni film of the second layer is 20 nm, an Au film of the second layer is 500 nm) is formed. In this way, a Schottky electrode 37 is formed under the conditions contacting with the n-type GaN layer 34 at the opening portion of a SiO₂ film 35. Here, the Ni film of the second layer in the Ni/Au/Ni/Au multilayer film is disposed as a barrier layer to prevent diffusion of Sn from an Au-Sn solder thin film to be used as the metal for bonding 15 formed upon one major surface of the first support substrate 16.

After this, as same as the seventh embodiment, by carrying out such processes as bonding the first support substrate 16 formed the metal for bonding 15, peeling off the base substrate 31, bonding the second support substrate 18 formed the metal for bonding, etc., the intended GaN-based Schottky diode is manufactured. In the GaN-based Schottky diode manufactured in this way, the Schottky electrode 37 is formed upon one surface of the n-type GaN-based layer 34, and the ohmic electrode is formed upon one surface of the n⁺-type GaN-based layer 33 are formed. Therefore, in the Gan-based Schottky diode, between the Schottky electrode 37 and the ohmic electrode, electric current flows in the laminated direction of the n⁺-type GaN layer 33 and the n-type GaN-based layer 34, in other words, in the vertical direction. That is, the Gan-based Schottky diode is a vertical direction conductive type.

According to the eighth embodiment, in the vertical direction conductive type GaN-based Schottky diode, the same advantages as the seventh embodiment can be obtained.

### The ninth embodiment

A method for manufacturing a large area power GaN-based Schottky diode according to the ninth embodiment is explained.

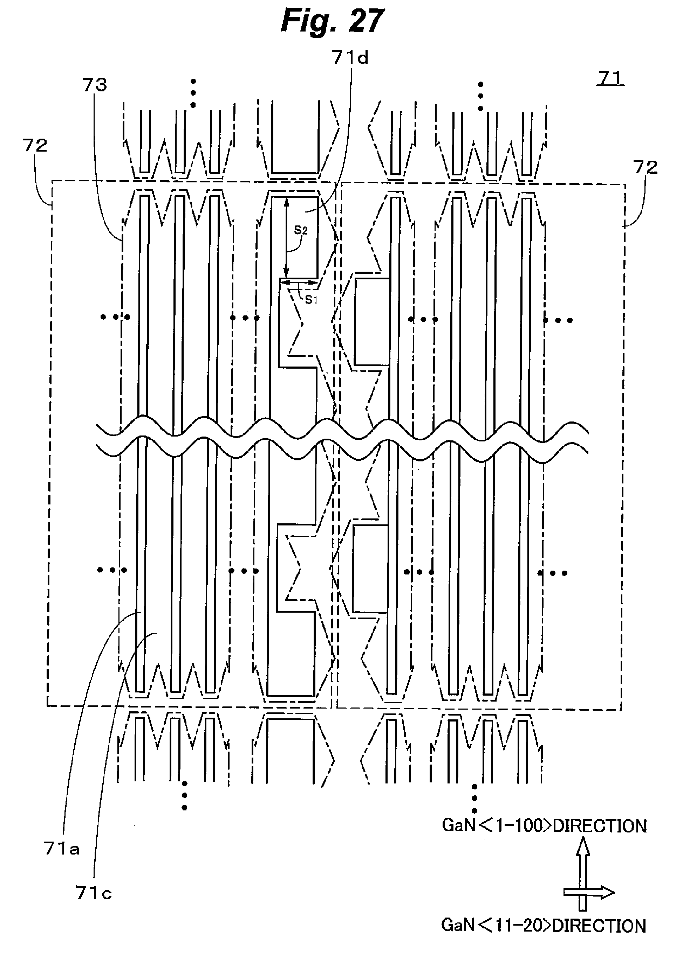

First, as shown in Fig. 27, a growth mask 71 is formed on a base substrate (not illustrated). The growth mask 71 comprises a striped window 71a as the same as the striped window 12a of the growth mask 12 shown in Fig. 2, every rectangle chip region 72 which becomes finally a device. In one chip region 72, a plurality of striped windows 71a are included, for example, 600 in the 〈11-20〉 direction. For example, the length a of the striped window 71a is 1200 µm, the width b is 1 µm, the width of a mask portion 71c is 3 µm, the interval p₁ of the striped window 71a is 4 µm. In this case, for example, the size of the chip region 72 is 2400 µm in the 〈11-20〉 direction, and 1300 µm in the 〈1-100〉 direction. In this case, the growth mask 71 comprises, in addition to the striped window 71a, a coalescence prevention window 71d so as to prevent coalescence of the island-like GaN-based semiconductor layers 13 each other in the 〈11-20〉 direction growing from each striped window 71a along a pair of sides opposing each other of the chip region 72 adjacent to each other. The coalescence prevention window 71d is comprised with rectangle windows disposed upon a side of a same shape window as the striped window 71a which are formed with a 20 µm pitch, for example and have a size of s₁ x s₂ (for example, s₁ = 4µm , s₂ = 10 µm) having a side parallel to the 〈11-20〉 direction and the 〈1-100〉 direction. The distance between the coalescence prevention window 71d formed along a pair of sides opposing to the chip region 72 adjacent to each other is, for example, 15 µm.

Next, using the growth mask 71, an n⁺-type GaN layer 73 doped with Si as an n-type impurity is grown into an island-like shape in the (0001) plane orientation by an MOCVD method. The growth of the n⁺-type GaN layer 73 is, for example, made at the temperature of 1100°C, at the pressure of 60 kPa which becomes growth mode that the growth proceeds both in vertical and lateral directions. In this case, in each chip region 72, the n⁺-type GaN layers 73 grown from each striped window 71a coalesce each other, and a large n⁺-type GaN layer 73 as a whole can be obtained. At the growth of the n⁺-type GaN layer 73, for example, TMG and NH₃ are used as raw gas, H₂ and N₂ are used as carrier gas, and SiH₄ diluted with nitrogen is used as an n-type dopant. The impurity concentration of the n⁺-type GaN layer 73 is, for example, 1 x 10¹⁸cm⁻³. For example, when the thickness of the n⁺-type GaN layer 73 reaches to 10 µm, reducing the supply amount of SiH₄, an n-type GaN layer is grown to 8 µm in thickness. The impurity concentration of the n-type GaN layer is, for example, to be 1 x 10¹⁶cm⁻³.

The reason that the coalescence prevention window 71d blocks the growth of the n⁺-type GaN layer 73 in the 〈11-20〉 direction is essentially the same as the case using the growth mask 12 shown in Fig 5. That is, making the coalescence prevention window 71d an origin, a {1-100} plane with slow growth rate is formed upon the n⁺-type GaN layer 73. The {1-100} plane is inclined to 30° or 90° for the {11-20} plane, and becomes a triangular geometry as shown in Fig. 27, therefore the growth is stopped. As a result, as shown in Fig. 27, the n⁺-type GaN layer 73 and the n-type GaN layer between the chip regions 72 adjacent to each other are separated each other through a portion of a device separating zone.

After this, as the same as the seventh embodiment, carrying out such processes of bonding the first support substrate 16 formed the metal for bonding 15, peeling a base substrate off, bonding of the second support substrate 18 formed the metal for bonding, an intended large area power GaN-based Schottky diode is manufactured. In the large area power GaN-based Schottky diode manufactured in this way, a Schottky electrode is formed upon one plane of the n-type GaN layer 74, and an ohmic electrode is formed upon one plane of the n⁺-type GaN layer 73. Therefore, in the large area power GaN-based Schottky diode, the electric current flows in the laminated direction of the n⁺-type GaN layer 73 and the n-type GaN layer between the Schottky electrode and the ohmic electrode, in other words, in the vertical direction. That is, the large area power GaN-based Schottky diode is a vertical direction conductive type.

According to the ninth embodiment, in the large area power GaN-based Schottky diode of the vertical direction conductive type, the same advantages as the seventh embodiment can be obtained.

### The tenth embodiment

A method for manufacturing a GaN-based Schottky diode according to the tenth embodiment is explained.

First, upon a (111) plane-oriented Si substrate 41a as same as the fourth embodiment, for example, a 30-nm-thick AlN film and a 20-nm-thick GaN film are grown in order, for example, at the temperature of 1100°C by, for example, an MOCVD method, and a growth mask 42 is formed upon a base substrate obtained in this way as the same as the first embodiment. The growth mask 42 comprises a striped window 42a and an auxiliary striped window (not illustrated) as the same as the growth mask 12 of the first embodiment. For example, the growth mask 42 is formed by a 0.3-µm-thick SiO₂ film, the length a of the striped window 42a is 1000 µm, the width b is 10 µm, the interval p₁ of the striped window 42a is 90 µm, the interval p₂ is 1010 µm, the width of a mask portion is 80 µm, the length c of the auxiliary striped window is 120 µm, the width d is 10 µm, the distance between the striped window 42a and the striped window 42a in the 〈1-100〉 direction is 10µm, the overlapping length q of the end portion of the striped window 42a and the auxiliary striped window 42b is 55 µm.

Next, using the growth mask 42, the n⁺-type GaN layer 43 doped with Si as an n-type impurity is grown into an island-like shape in the (0001) plane orientation by an MOCVD method. The thickness of the n⁺-type GaN layer 43 is, for example, 8 µm, and the impurity concentration is, for example, 5 x 10¹⁸cm⁻³. The distance between the n⁺-type GaN layer 43 and the n⁺-type GaN layer 43 is, for example, about 10 µm. The growth of the n⁺-type GaN layer 43 is, for example, made at the temperature of 1100°C, and the pressure of 30 kPa. At the growth of the n⁺-type GaN layer 43, for example, TMG and NH₃ are used as raw gas, H₂ and N₂ are used as carrier gas, and SiH₄ diluted with nitrogen is used as an n-type dopant. In this case, one island-like n⁺-type GaN layer 43 is the one grown from one striped window 42a. Next, in order to promote the growth in the vertical direction, increasing growth pressure, for example, to 80 kPa, adjusting the crystal growth conditions, the n-type GaN layer 44 is grown upon the n⁺-type GaN layer 43 by an MOCVD method. The thickness of the n-type GaN layer 44 is, for example, 5 µm, the impurity concentration is, for example, to be 1 x 10¹⁶cm⁻³. The distance in the 〈11-20〉 direction of the whole of the n⁺-type GaN layer 43 and the n-type GaN layer 44 after growing the n-type GaN layer 44 in this way is, for example, about 5 µm. As shown in Fig. 16A, in the n⁺-type GaN layer 43 and the n-type GaN layer 44, threading dislocations 45 are formed at the directly above portion of the striped window 42a.

After this, forming a Schottky electrode (not illustrated) upon the n-type GaN layer 44, further as the same as the seventh embodiment, carrying out processes of bonding the first support substrate 16 formed the metal for bonding 15, peeling the base substrate off, bonding the second support substrate formed the metal for bonding, etc., an intended GaN-based Schottky diode is manufactured.

According to the tenth embodiment, in the GaN-based Schottky diode, the same advantages as the seventh embodiment can be obtained.

### The eleventh embodiment

A method for manufacturing a GaN-based light-emitting diode according to the eleventh embodiment is explained.

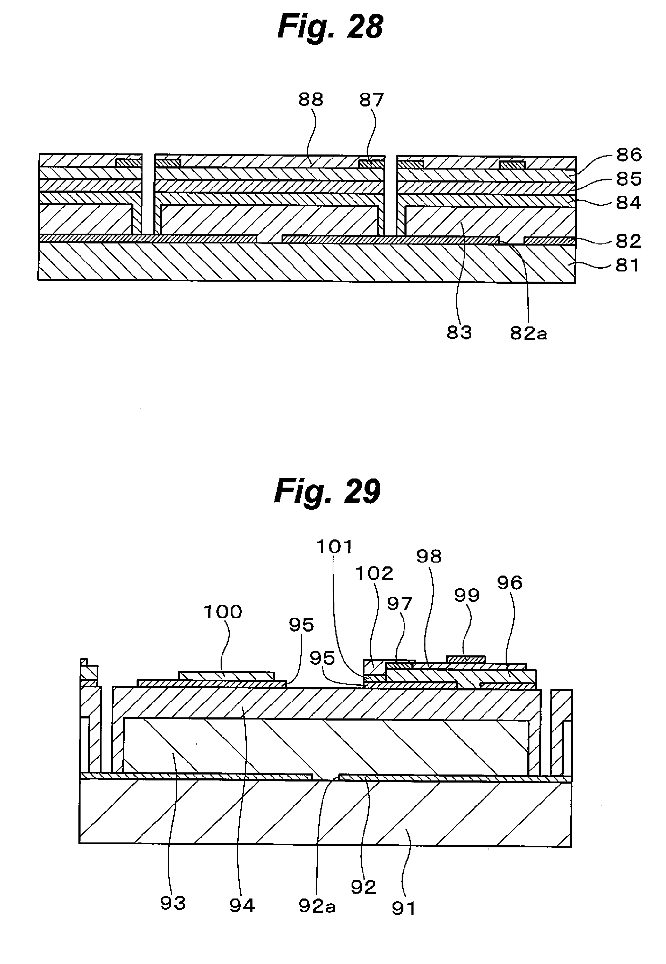

First, as the same as the first embodiment, as shown in Fig. 28, a growth mask 82 is formed upon a base substrate 81. As the base substrate 81, a substrate grown a 2-µm-thich GaN layer upon a C-plane sapphire substrate is used. The growth mask 82 comprises a striped window 82a and an auxiliary striped window (not illustrated) as same as the growth mask 12. For example, the growth mask 82 is formed with a 0.3-µm-thick SiO₂ film, the length a of the striped window 82a is 1000 µm, the width b is 10 µm, the interval p₁ of the striped window 82a is 90 µm, the interval p₂ is 1010 µm, the width of a mask portion is 80 µm, the length c of the auxiliary striped window is 120 µm, the width d is 10 µm, the distance between the striped window 32a and the striped window 32a in the 〈1-100〉 direction is 10 µm, and the overlapping length q of the end portion of the striped window 32a and the auxiliary striped window 32b is 55 µm.

Next, using the growth mask 82, an n⁺-type GaN layer 83 doped with Si as an n-type impurity method is grown into an island-like shape in the (0001) plane orientation by an MOCVD. The thickness of the n⁺-type GaN layer 83 is, for example, 10 µm, and the impurity concentration is, for example, to be 5 x 10¹⁸cm⁻³. The distance between the n⁺-type GaN layer 83 and the n⁺-type GaN layer 83 is, for example, about 10 µm. The growth of the n⁺-type GaN layer 83 is made, for example at the temperature of 1100°C and the pressure of 30 kPa. At the growth of the n⁺-type GaN layer 83, TMG and NH₃ are used as raw gas, H₂ and N₂ are used as carrier gas, and SiH₄ diluted with nitrogen is used as an n-type dopant. In this case, one island-like n⁺-type GaN layer 83 is the one grown from one striped window 32a. Next, adjusting the crystal growth conditions to promote the growth in the vertical direction, an n-type GaN layer 84 is grown upon the n⁺-type GaN layer 83 by a MOCVD method. The thickness of the n-type GaN layer 84 is, for example, 5 µm, the impurity concentration is, for example, to be 1 x 10¹⁶cm⁻³. The distance in the 〈11-20〉 direction of the whole of the n⁺-type GaN layer 83 and the n-type GaN layer 84 after growing the n-type GaN layer 84 in this way is, for example, about 5 µm. In the n⁺-type GaN layer 83 and the n-type GaN layer 84, threading dislocations are formed at the directly above portion of the striped window 82a, but the illustration is omitted.

Continuously, by an MOCVD method, for example, a light emitting layer 85 and a p⁺-type GaN layer 86 having an InGaN-GaN multiquantum well structure (MQW) are grown upon the n-type GaN layer 84. The thickness of the light emitting layer 85 is generally 50 nm or less, the thickness of the p⁺-type GaN layer 86 is very thin, for example, about 100 nm, therefore the growth of these light emitting layer 85 and the p⁺-type GaN layer 86 into the side surface of the n-type GaN layer 84 can be almost neglected.

Next, after forming an insulator film upon the whole surface, for example, a 1-µm-thick SiO₂ film 35 by a plasma CVD method, for example, the SiO₂ film 87 is patterned into a predetermined shape by photolithography and etching, and the p⁺-type GaN layer 86 is partially exposed.

Next, after forming an ohmic metal film upon the whole surface, for example, by a vacuum evaporation method, the metal film is patterned into a predetermined shape by photolithography and etching. In this way, a p-side electrode 88 is formed under the conditions contacting with the p⁺-type GaN layer 86. As the ohmic metal film, for example, a double-layered film of Ni/Au is used. The thickness of each film is, for example, a Ni film is to be 50 nm, and an Au film 500 nm.

After this, as the same as the seventh embodiment, bonding of the first support substrate 16 formed the metal for bonding 15, and peeling off the base substrate 81 are carried out.

Next, upon the surface of the n⁺-type GaN layer 83 exposed by peeling the base substrate 81, for example, a ZnO thin film is formed as a transparent ohmic electrode.

As explained above, an intended GaN-based light-emitting diode can be manufactured.

According to the eleventh embodiment, in the GaN-based light-emitting diode, the same advantages as the first and seventh embodiments can be obtained.

### The twelfth embodiment

A method for manufacturing of a two-terminal and a three-terminal GaN-based compound semiconductor device according to the twelfth embodiment is explained.

First, as the same as the first embodiment, as shown in Fig. 29, a growth mask 92 is formed upon a base substrate 91. As the base substrate 91, for example, a substrate grown a 2-µm-thick GaN layer upon a C-plane sapphire substrate is used. The growth mask 92 comprises a striped window 92a and an auxiliary striped window (not illustrated) as the same as the growth mask 12. For example, the growth mask 92 is formed with a 0.3-µm-thick SiO₂ film, the length a of the striped window 92a is 1000 µm, the width b is 5-µm, the interval p₁ of the striped window 92a is 90 µm, the interval p₂ is 1010 µm, the width of a mask portion is 80 µm, the length c of the auxiliary striped window is 120 µm, the width d is 10 µm, the distance between the striped window 92a and the striped window 92a in the 〈1-100〉 direction is 10 µm, the overlapping length q of the end portions of the striped window 92a with the auxiliary striped window 92b is 55 µm.

Next, using the growth mask 92, an n⁺-type GaN layer 93 doped with Si as an n-type impurity is grown in an island-like shape in the (0001) plane orientation by an MOCVD method. The thickness of the n⁺-type GaN layer 93 is, for example, 15 µm, the impurity concentration is, for example, to be 1 x 10¹⁷cm⁻³. The distance between the n⁺-type GaN layer 93 and the n⁺-type GaN layer 93 is, for example, about 5 to 10 µm. The growth of the n⁺-type GaN layer 93 is made, for example, at the temperature of 1100°C and the pressure of 30 kPa. At the growing time of the n⁺-type GaN layer 93, for example, TMG and NH₃ are used as raw gas, and H₂ and N₂ are used as carrier gas, SiH₄ diluted with nitrogen is used as an n-type dopant. In this case, one island-like n⁺-type GaN layer 93 is the one grown from one striped window 92a. Next, adjusting the crystal growth conditions to promote the growth in the vertical direction, an n-type GaN layer 94 is grown upon the n⁺-type GaN layer 93 by an MOCVD method. The thickness of the n-type GaN layer 94 is, for example, 4 µm, the impurity concentration is, for example, to be 1 x 10¹⁶cm⁻³. The distance in the 〈11-20〉 direction of the whole of the n⁺-type GaN layer 93 and the n-type GaN layer 94 after growing the n-type GaN layer 94 in this way is, for example, bout 5 µm. In the n⁺-type GaN layer 93 and the n-type GaN layer 94, threading dislocations are formed at the directly above portion of the striped window 92a, but the illustration is omitted.

Continuously, a p⁺-type GaN layer 95 is grown upon the n-type GaN layer 94 by an MOCVD method. The thickness of the p⁺-type GaN layer 95 is, for example, about 500 nm, and the impurity concentration is, for example, to be 1 x 10¹⁹cm⁻³. Next, the directly below portion of a gate of a three-terminal device (transistor), which is explained later, in the p⁺-type GaN layer 95 is removed by etching.

Next, an n-type GaN layer 96 and an AlGaN layer 97 are grown in order upon the whole surface by an MOCVD method. The thickness of the n-type GaN layer 96 is, for example, about 800 nm, and the impurity concentration is, for example, to be 1 x 10¹⁷cm⁻³. The thickness of the AlGaN layer 97 is, for example, 30 nm, the Al composition is, for example, to be 0.25.

Next, in order to make a three-terminal device (transistor) an enhanced mode type, the AlGaN layer 97 of the gate portion is removed by a dry etching. At an adjacent of the interface between the AlGaN layer 97 and the n-type GaN layer 96, two-dimensional electron gas is generated, but by removing the AlGaN layer 97 of a gate portion in this way, the two-dimensional electron gas becomes non-existent at the gate portion, and by a band pull-up effect by the p⁺-type GaN layer 95, the n-type GaN layer 96 under the gate becomes depleted.

Next, after forming an insulator film upon the whole surface, for example, a 20-nm-thick SiO₂ film by a plasma CVD method, for example, the SiO₂ film is patterned into an predetermined shape by photolithography and etching. In this way, a gate insulator film 96 made of a SiO₂ film is formed upon the n-type GaN layer 96 of a gate portion.

Next, after forming a metal film for a Schottky electrode formation upon the whole surface by a vacuum evaporation method, for example, the metal film is patterned into a predetermined shape by photolithography and etching. As the metal film, for example, a Ni/Au double-layered film (the thickness of each film is that a Ni film of the first layer is 50 nm, and an Au film of the first layer is 500 nm) is formed. In this way, a gate electrode 99 is formed upon the gate insulator film 98.

Next, the n-type GaN layer 96 is patterned into a predetermined shape by photolithography and dry etching, and the p⁺-type GaN layer 95 is partially exposed.

Next, the p⁺-type GaN layer 95 of the directly above portion of the striped window 92a of the growth mask 92 is removed by etching. This is for making device separateion between a two-terminal device and a three-terminal device.

Next, after forming an ohmic metal film upon the whole surface by, for example, a vacuum evaporation method, the metal film is patterned into a predetermined shape by photolithography and etching. As the metal film, for example, a Ni/Au double-layered film (the thickness of each film is that for example, a Ni film of the first layer is 50 nm, and an Au film of the first layer is 500 nm) is formed. In this way, along with forming an anode electrode 100 upon the p⁺-type GaN layer 95 in a two-terminal device portion , an ohmic electrode 101 is formed under the conditions contacting with the n-type GaN layer 96 upon the p⁺-type GaN layer 95 in a three-terminal device portion.

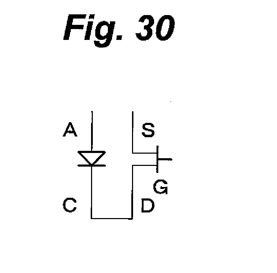

Next, after forming an ohmic metal film upon the whole surface by, for example, a vacuum evaporation method, the metal film is patterned into a predetermined shape by photolithography and etching. As the metal film, for example, a multilayer film of Ti/Al/Au (the thickness of each film is, for example, a Ti film is 5 nm, an Al film is 45 nm, and an Au film is 10 nm) is formed. In this way, in the three-terminal device portion, a source electrode 102 is formed upon the ohmic electrode 101 and the AlGaN layer 97. The three-terminal device is a vertical, enhancement type insulated gate FET. Also, the two-terminal device is a p-n junction diode. The equivalent circuit of the two-terminal and the three-terminal GaN-based compound semiconductor device is shown in Fig. 30. As shown in Fig. 30, in the circuit, a drain of the enhancement-type insulated gate FET and an anode of the p-n junction diode are commonly connected. As the source electrode 102 of the enhancement-type insulated gate FET is contact with the p⁺-type GaN layer 95, the portion becomes a diode.

After this, as the same as the seventh embodiment, bonding the first support substrate 16 formed the metal for bonding 15, peeling off the base substrate 91, and bonding of the second support substrate 18 formed the metal for bonding are carried out. As the first support substrate 16, for example, an AlN substrate is used. Upon the major surface of the AlN substrate, a line contacting to the anode electrode 100 of the p-n junction diode is formed in addition to the gate electrode 99 and the source electrode 102, further upon the above, an Au/Sn solder is formed in about 1 µm thick. As the second support substrate 18, for example, an Au-plated copper plate is used. The Au-plated copper plate is bonded upon the surface of an n⁺-type GaN layer 93 exposed by peeling of the base substrate 91.

From the above, the two-terminal and three-terminal GaN-based compound semiconductor device is completed.

Upon the major surface of the AlN substrate as the first support substrate 16, the source electrode 102 and the anode electrode 100 may be formed together. By doing this, by the two-terminal and three-terminal GaN-based compound semiconductor device, the typical unit circuit of a power circuit can be composed.

According to the twelfth embodiment, in the two-terminal and three-terminal GaN-based compound semiconductor device, the same advantages as the first and seventh embodiments can be obtained.

### The thirteenth embodiment

A GaN-based semiconductor device and a method for manufacturing thereof according to the thirteenth embodiment are explained.

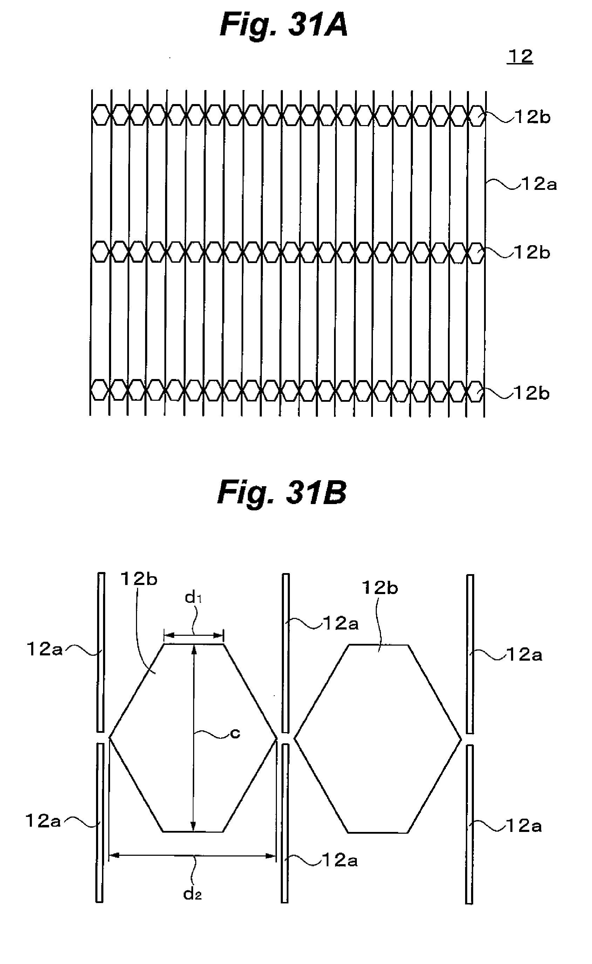

In the thirteenth embodiment, the growth mask 12 as shown in Fig. 31A and Fig. 31B is used. Here, Fig. 31B is a plan view enlarged a portion of the growth mask 12 shown in Fig. 31A. As shown in Fig. 31A and Fig. 31B, in the growth mask 12, the point that the auxiliary striped window 12b has a long and thin hexagonal shape in the 〈1-100〉 direction of the GaN-based semiconductor layer 13 is different from the growth mask 12 shown in Fig. 2. In other words, in the growth mask 12 shown in Fig. 2, for the width d of the auxiliary striped window 12b is constant in the 〈1-100〉 direction of the GaN-based semiconductor layer 13, in the growth mask 12 shown in Fig. 31A and Fig. 31B, the width d of the auxiliary striped window 12b is linearly increased from the width d₁ at the both ends in the 〈1-100〉 direction of the GaN-based semiconductor layer 13 to the width d₂ of the central portion. An example of the size of each portion of the growth mask 12 is that the length a of the striped window 12 is 1492 µm, the width b is 5 µm, the interval p₁ of the striped window 12 is 200 µm, the interval p₂ is 1500 µm, the length c of the auxiliary striped window 12b is 208 µm, the width d₁ is 69.5 µm, the width d₂ is 185 µm, but are not limited to these.

As the other respects are the same as the first embodiment, the explanations are omitted.

According to the thirteenth embodiment, the same advantages as the first embodiment can be obtained.

### The fourteenth embodiment

A GaN-based semiconductor device and a method for manufacturing thereof according to the fourteenth embodiment are explained.

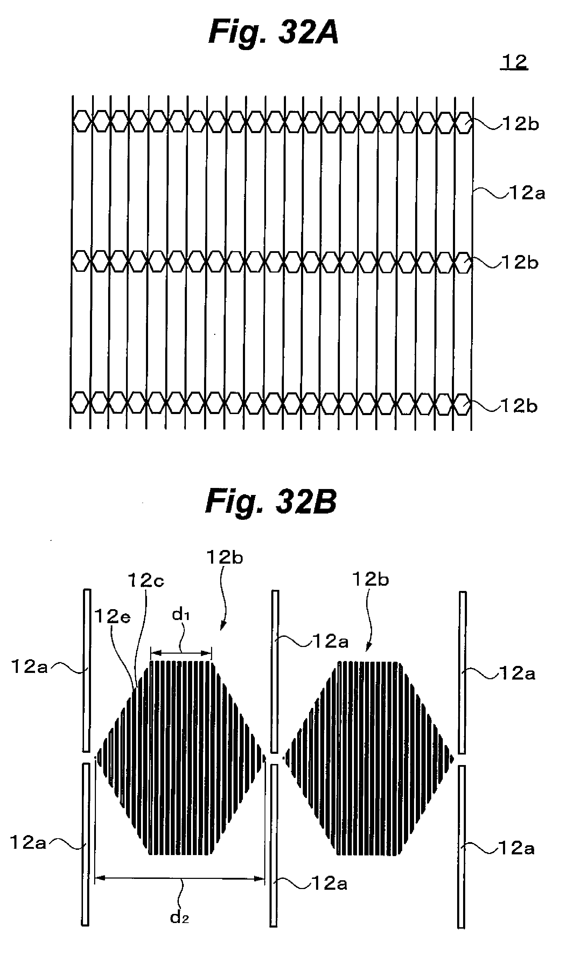

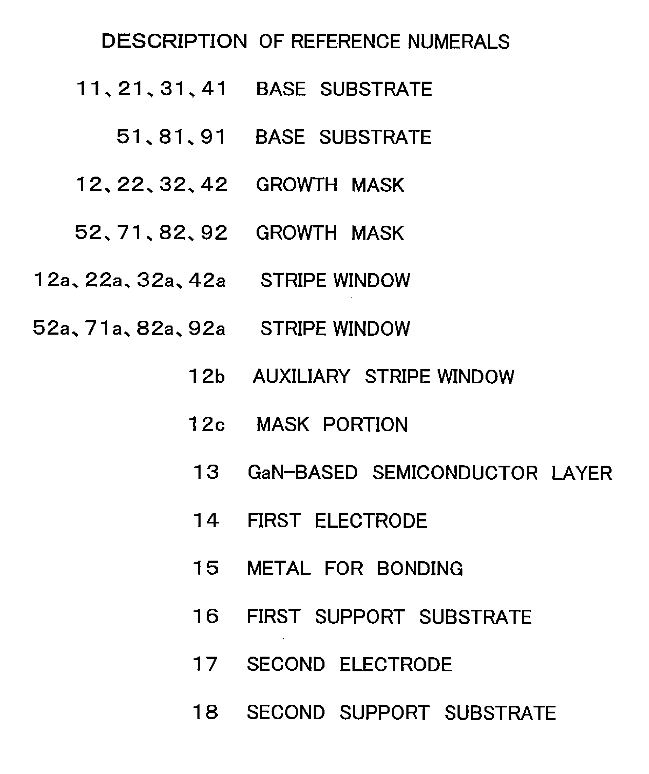

In the fourteenth embodiment, the growth mask 12 shown in Fig. 32A and Fig. 32B is used. Here, Fig. 32B is a plan view enlarging a portion of the growth mask 12 shown in Fig. 32A. As shown in Fig. 32A and Fig. 32B, in the growth mask 12, the auxiliary striped window 12b has the same hexagonal shape as the auxiliary striped window 12b in the growth mask 12 shown in Fig. 31A and Fig. 31B as a whole, and is made by that the rectangular striped window 12e extending in the 〈1-100〉 direction of the GaN-based semiconductor layer 13 and the same rectangular mask portion 12c are formed alternately in the 〈111-20〉 direction of the GaN-based semiconductor layer 13. An example of the size of each portion of the growth mask 12 is that the length a of the striped window 12 is 1492 µm, the width b is 5 µm, the interval p₁ of the striped window 12 is 200 µm, the interval p₂ is 1500 µm, the length c of the auxiliary striped window 12b is 208 µm, the width d₁ is 69.5 µm, the width d₂ is 185 µm, the width of each striped window 12e composing the auxiliary striped window 12b is 3 µm, the width of the mask portion 12c between the striped windows 12e is 3 µm, but are not limited to these.

As the other respects are the same as the first embodiment, the explanations are omitted.

According to the fourteenth embodiment, the same advantages as the first embodiment can be obtained.

The embodiments of the present invention are precisely explained, however, the present invention is not limited to the embodiments, and a variety of variation based upon the technical idea of the present invention is possible.

For example, numerical numbers, structures, materials, etc. presented in the aforementioned embodiments are only examples, and the different numerical numbers, structures, materials, etc. may be used as necessary.

## Claims

1. A method for manufacturing a semiconductor device comprising steps of:
forming a growth mask with a plurality of striped openings directly or indirectly upon a substrate that comprises a material differing from GaN-based semiconductor; and
growing a plurality of island-like GaN-based semiconductor layers upon the substrate using the growth mask in the (0001) plane orientation in a manner such that the 〈1-100〉 direction of the GaN-based semiconductor layers extends in a direction parallel to the striped openings of the growth mask.

2. The method for manufacturing a semiconductor device according to claim 1 wherein sides of the GaN-based semiconductor layers are formed by (1-10α) plane (α is an arbitrary integer), (11-2β) plane (β is an arbitrary integer) or planes crystallographically equivalent to these, or, sides of the GaN-based semiconductor layers include (1-10α) plane (α is an arbitrary integer).

3. The method for manufacturing a semiconductor device according to claim 2 wherein the growth mask comprises a plurality of striped openings which are arranged in the first direction parallel to the 〈11-20〉 direction of the GaN-based semiconductor layers and the second direction parallel to the 〈1-100〉 direction of the GaN-based semiconductor layers periodically at the first interval and the second interval respectively and extend in the second direction; and auxiliary striped openings disposed on the bisecting line of the region between a pair of the striped openings adjacent to each other in the first direction in a manner such that the auxiliary striped openings overlap with end portions opposing each other of a pair of the striped openings adjacent to each other in the second direction for the predetermined distance, respectively.

4. The method for manufacturing a semiconductor device according to claim 2 wherein the growth mask comprises a plurality of striped openings which are arranged in the first direction parallel to the 〈11-20〉 direction of the GaN-based semiconductor layers periodically and extend in the second direction parallel to the 〈1-100〉 direction of the GaN-based semiconductor layers; and a plurality of striped openings which are arranged periodically in the first direction at the same interval as the striped openings and shifted by a half of the interval with respect to the striped openings and extends in the second direction in a manner such that the plurality of striped openings overlap with end portions of the striped openings for the predetermined distance in the second direction.

5. The method for manufacturing a semiconductor device according to claim 1 wherein the GaN-based semiconductor layer comprises more than two layers including at least one layer among an n-type layer, an undoped layer and a p-type layer.

6. The method for manufacturing a semiconductor device according to claim 1 further comprising a step of bonding the first support substrate upon the upper surface side of the GaN-based semiconductor layers after growing the GaN-based semiconductor layers upon the substrate, and peeling the first support substrate and the GaN-based semiconductor layers off from the substrate.

7. The method for manufacturing a semiconductor device according to claim 6 further comprising a step of forming one or a plurality of electrodes upon the upper surface of the GaN-based semiconductor layers after growing the GaN-based semiconductor layers upon the substrate and before bonding the first support substrate upon the upper surface side of the GaN-based semiconductor layers.

8. The method for manufacturing a semiconductor device according to claim 6 further comprising a step of removing at least a portion of the growth mask after growing the GaN-based semiconductor layers upon the substrate and before bonding the first support substrate upon the upper surface side of the GaN-based semiconductor layers.

9. The method for manufacturing a semiconductor device according to claim 6 further comprising a step of forming one or a plurality of electrodes upon the exposed surface of the GaN-based semiconductor layers after peeling the first support substrate and the GaN-based semiconductor layers off from the substrate.

10. The method for manufacturing a semiconductor device according to claim 6 wherein one or a plurality of conductor thin films or conductor lines are formed upon the major surface of the first support substrate on the side bonded with the GaN-based semiconductor layers.

11. The method for manufacturing a semiconductor device according to claim 6 further comprising a step of bonding the second support substrate upon the exposed surface side of the GaN-based semiconductor layers after peeling the first support substrate and the GaN-based semiconductor layers off from the substrate.

12. A semiconductor device comprising:
a substrate that comprises a material differing from GaN-based semiconductor;
a growth mask with one or a plurality of striped openings disposed directly or indirectly upon the substrate; and
one or a plurality of island-like GaN-based semiconductor layers grown upon the substrate using the growth mask in the (0001) plane orientation,
the striped openings of the growth mask extending in a direction parallel to the 〈1-100〉 direction of the GaN-based semiconductor layers.

13. The semiconductor device according to claim 12 wherein the growth mask comprises a plurality of striped openings which are arranged in the first direction parallel to the 〈11-20〉 direction of the GaN-based semiconductor layers and the second direction parallel to the 〈1-100〉 direction of the GaN-based semiconductor layers periodically at the first interval and the second interval respectively and extend in the second direction; and auxiliary striped openings disposed on the bisecting line of the region between a pair of the striped openings adjacent to each other in the first direction in a manner such that the auxiliary striped openings overlap with end portions opposing each other of a pair of the striped openings adjacent to each other in the second direction for the predetermined distance, respectively.

14. The semiconductor device according to claim 12 wherein the growth mask comprises a plurality of striped openings which are arranged in the first direction parallel to the 〈11-20〉 direction of the GaN-based semiconductor layers periodically and extend in the second direction parallel to the 〈1-100〉 direction of the GaN-based semiconductor layers; and a plurality of striped openings which are arranged periodically in the first direction at the same interval as the striped openings and shifted by a half of the interval with respect to the striped openings and extends in the second direction in a manner such that the plurality of striped openings overlap with end portions of the striped openings for the predetermined distance in the second direction.
